# EUROPEAN PATENT SPECIFICATION

(11) **EP 4 386 831 B1**
(45) Date of publication and mention of the grant of the patent: **11.02.2026**
(21) Application number: 22855715.3
(22) Date of filing: 24.03.2022
(51) Int. Cl.: H01L 23/495, H01L 23/367, H01L 23/053, H01L 23/433, H01L 21/56, H01L 23/31, H10F 39/00

(54) **SEMICONDUCTOR DEVICE PACKAGE AND HEAT DISSIPATING LEAD FRAME**
HALBLEITERBAUELEMENTGEHÄUSE UND WÄRMEABLEITENDER LEITERRAHMEN
BOÎTIER DE DISPOSITIF À SEMI-CONDUCTEUR ET GRILLE DE CONNEXION DE DISSIPATION DE CHALEUR

(30) Priority: 11.08.2021 JP 2021131233
(43) Date of publication of application: 19.06.2024
(73) Proprietor: Sony Semiconductor Solutions Corporation, Atsugi-shi, Kanagawa 243-0014 (JP)
(72) Inventor: OOTAKI, Yutaka, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/013797
(87) International publication number: WO 2023/017649

(56) References cited:
- JP-A- 2006 345 196
- JP-A- 2016 213 245
- JP-A- 2016 213 245
- JP-A- H0 521 665
- JP-A- H0 521 665
- JP-A- H0 846 086
- JP-A- H0 846 086
- JP-A- H02 291 154
- JP-A- H02 291 154
- US-A- 4 882 212
- US-A- 6 137 170
- US-A1- 2016 351 731

## Description

### [Technical Field]

The present disclosure relates to a semiconductor device package on which a semiconductor chip or the like is mounted and sealed, and a lead frame with high heat dissipation properties used in the package.

### [Background Art]

Conventionally, various means have been proposed as heat dissipation measures for semiconductor elements, and a semiconductor package described in PTL 1, for example, is known as one of them. In this semiconductor package, a lead frame to which a semiconductor chip is die-bonded is sealed with resin, and the bottom part of the lead frame, in particular, to which the semiconductor chip is die-bonded, is exposed to the outside.

That is, in this semiconductor package, Joule heat generated from the semiconductor chip or the like is transmitted to the lead frame (through the die bonding resin) or is dissipated to the outside of the package through the substrate on which the semiconductor chip is mounted.

Furthermore, when Joule heat is generated in image sensors such as CMOS (complementary metal-oxide semiconductor) and CCD (charge coupled device), which are semiconductor devices, noise or the like may increase. For this reason, heat dissipation measures have become an important issue in semiconductor packages that mount these image sensors as well.

Therefore, a semiconductor package as described in, for example, PTL 2 has also been proposed. That is, in this semiconductor package, a heat sink is attached to the central portion of the substrate opposite to the image sensor mounting surface, that is, the central opening. Further examples are given in documents JP H02 291154 A, JP H08 46086 A, US 4 882 212 A, JP H05 21665 A, US 2016/351731 A1, US 6 137 170 A and JP 2016 213245 A.

### [Citation List]

### [Patent Literature]

[PTL 1]
   WO 2011-062148
[PTL 2]
   JP 2019-68017A

### [Summary]

### [Technical Problem]

However, in the semiconductor package described in PTL 1, there are limitations and restrictions on the size of the semiconductor package, and there is a possibility that the Joule heat generated by the semiconductor chip cannot be sufficiently dissipated.

In addition, in the semiconductor package described in PTL 2, since a heat sink is attached, a heat dissipation effect may be expected to some extent. However, since the heat sink is not attached directly to the semiconductor chip, there is room for improvement if it is desired to further increase the heat dissipation efficiency.

In particular, with the increase in the scale of semiconductor circuits in recent years, the increase in operating speed, and the further reduction in semiconductor chip size, there is a growing demand for effective heat dissipation measures for semiconductor chips that generate more significant heat and are equipped with conventional functions in an even smaller size than conventional chips.

Under these circumstances, it is desired to provide a semiconductor package capable of taking effective heat dissipation measures even for semiconductor chips in large-scale circuits and a lead frame with a high heat dissipation effect for use in the semiconductor package.

### [Solution to Problem]

According to a first aspect, the present invention provides a heat-dissipating lead frame according to independent claims 1 and 8. Further aspects of the present invention are set forth in the dependent claims.

A first semiconductor device package of the present disclosure includes an opening provided on a center side of a main body of a package; and a concave area provided on at least a front surface side of the main body at a center side including the opening, and recessed from an outer edge side that is outside the center side, wherein
a heat-dissipating lead frame having a number of heat-dissipating portions and mounting a semiconductor element on a central surface is attached to a rear surface side of the main body opposite to the front surface side.

A second semiconductor device package of the present disclosure is configured such that a mounting portion on the center side of the lead frame, on which the semiconductor element is mounted, fits into the opening.

A third semiconductor device package of the present disclosure is the first semiconductor package in which the concave area is provided not only on the front surface of the main body but also on the rear surface.

A fourth semiconductor device package of the present disclosure uses an interposer in at least a part of the main body of the package.

A first heat-dissipating lead frame according to the present disclosure includes a mounting surface for mounting a semiconductor chip formed of a material having heat dissipation properties and provided at a center on a front surface side of a mounting portion; and
a number of heat-dissipating portions provided around the mounting portion and/or on a rear surface side opposite to the mounting surface, wherein
with the mounting surface facing the front surface of the semiconductor package, the mounting surface is fitted into an opening provided in a semiconductor device package, and the lead frame is attached to a rear surface of the semiconductor device package.

A second heat-dissipating lead frame of the present disclosure is the first heat-dissipating lead frame, in which the mounting surface has a substantially rectangular shape, and the each of heat-dissipating portions is composed of a number of plate-shaped heat-dissipating fins formed around a lower surface side of the mounting surface.

In a third heat-dissipating lead frame of the present disclosure, the mounting portion is formed in a flat plate shape, and each of the heat-dissipating portions is formed such that a heat-dissipating pin protrude from a rear surface side opposite to the mounting surface on the front surface side of the mounting portion.

In a fourth heat-dissipating lead frame of the present disclosure, the mounting surface has a substantially rectangular shape, and
each of the heat-dissipating portions is composed of a number of plate-shaped heat-dissipating fins formed around an upper surface side of the mounting surface.

In the fourth heat-dissipating lead frame of the present disclosure, each of the heat-dissipating portions is a heat-dissipating pin having a shape of any one of a triangular prism, a quadrangular prism, a cylinder, and a polygonal prism, and are geometrically regularly arranged.

In a fifth heat-dissipating lead frame of the present disclosure, each of the heat-dissipating portions is formed only on an outer edge side of the rear surface side, avoiding directly below the center on the rear surface side of the mounting portion, and a pin-free area into which a jig for supporting the semiconductor package is inserted when die bonding the semiconductor chip is provided on the rear surface side directly below a central portion of the front surface side of the mounting portion.

In a sixth heat-dissipating lead frame of the present disclosure, each of the heat-dissipating portions adjacent to each other is connected by a thin film body.

### [Brief Description of Drawings]

[Fig. 1]

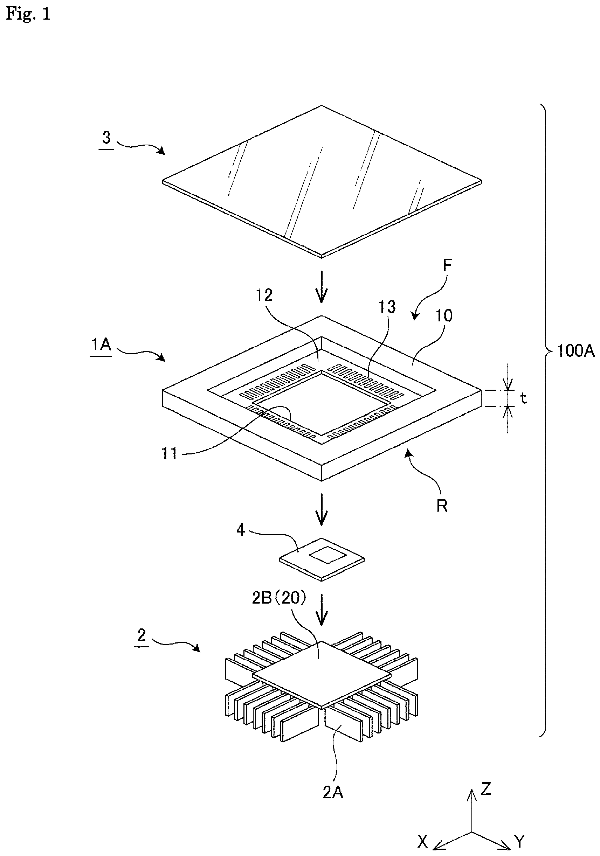

   Fig. 1 is an exploded perspective view showing a semiconductor device according to a first embodiment of the present disclosure.
[Fig. 2]

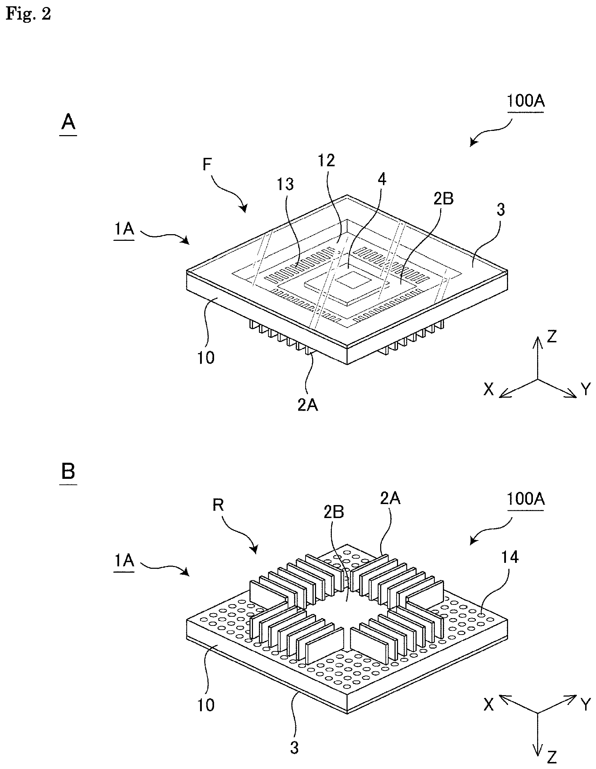

   Fig. 2A is a perspective view of the semiconductor device shown in Fig. 1 seen from above, and Fig. 2B is a perspective view of the device seen from below.
[Fig. 3]

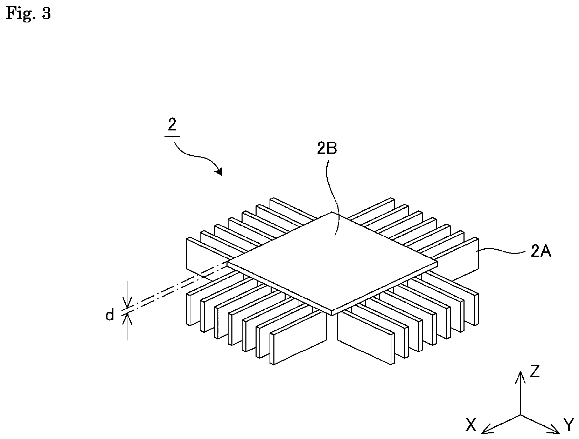

   Fig. 3 is a perspective view showing a welding-type heat-dissipating lead frame used in the semiconductor device of the present disclosure.
[Fig. 4]

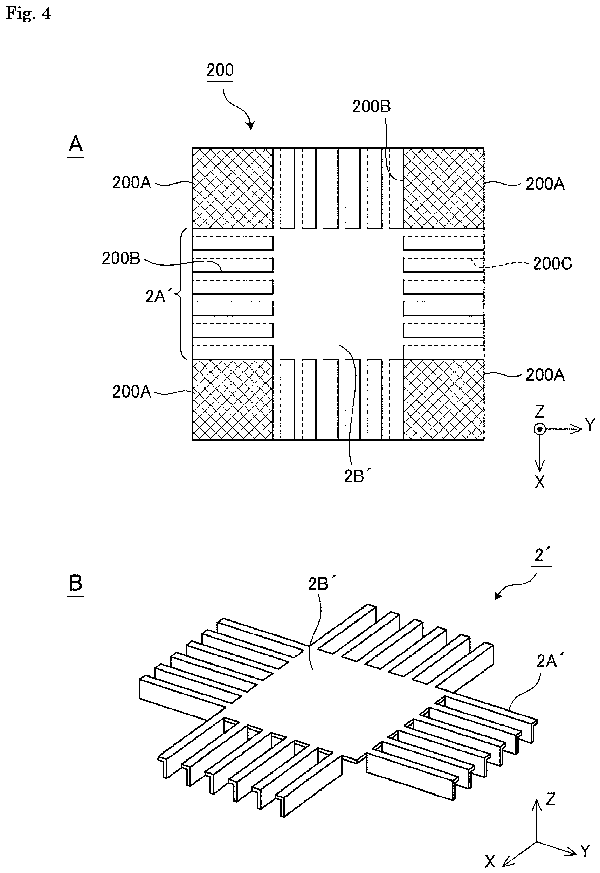

   Fig. 4A is an explanatory diagram showing a cutout portion of a metal plate used for manufacturing the heat-dissipating lead frame used in the semiconductor device of the present disclosure, and Fig. 4B is a perspective view showing a punching-type lead frame formed using the same.
[Fig. 5]

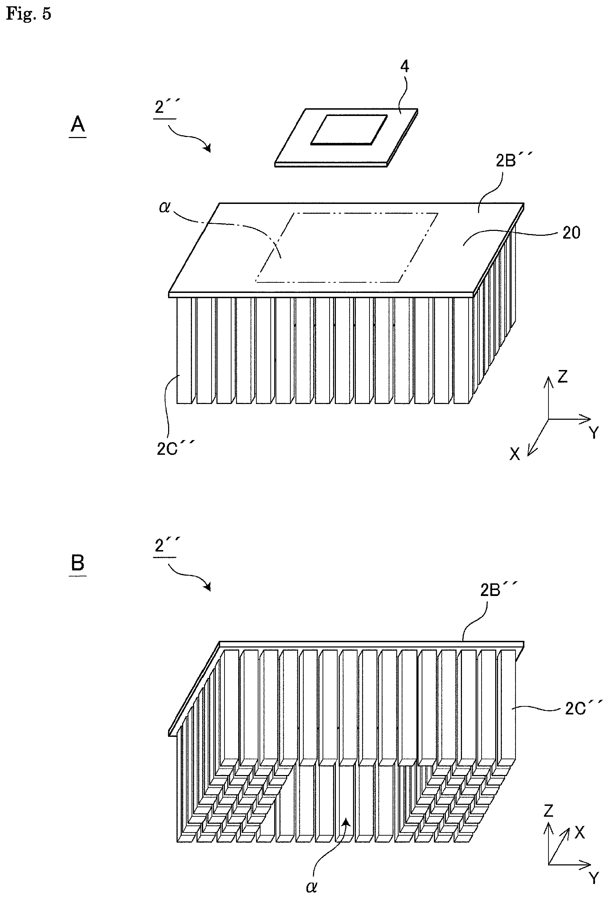

   Fig. 5 shows a casting-type lead frame equipped with a number of pins in the heat-dissipating portion used in the semiconductor device of the present disclosure, in which Fig. 5A is a perspective view seen from above and Fig. 5B is a perspective view seen from below.
[Fig. 6]

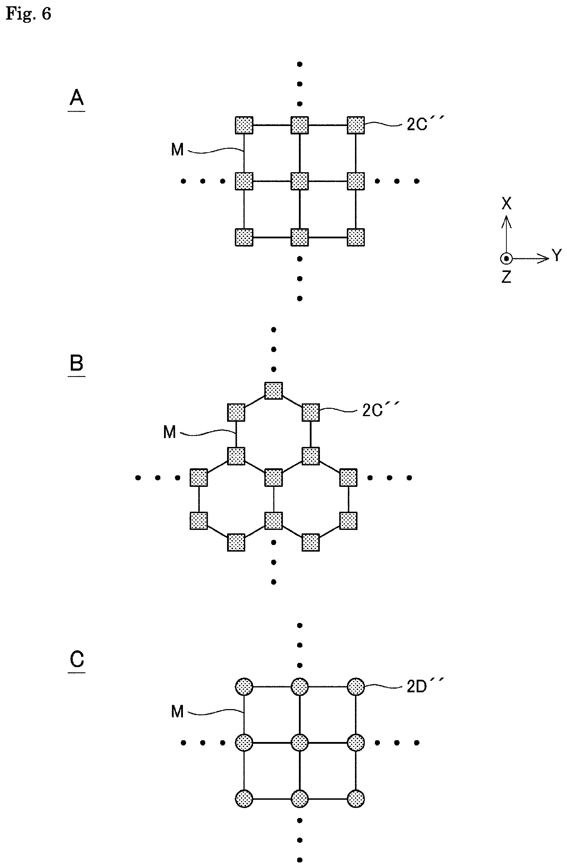

   Fig. 6 shows the arrangement state of a number of pins shown in Fig. 5, in which Fig. 6A is an explanatory diagram showing a state in which quadrangular-prism-type heat-dissipating pins are arranged in a grid pattern, Fig. 6B is an explanatory diagram showing a state in which quadrangular-prism-type heat-dissipating pins are arranged in a honeycomb shape, and Fig. 6C is an explanatory diagram showing a state where cylindrical heat-dissipating pins are arranged in a grid pattern.
[Fig. 7]

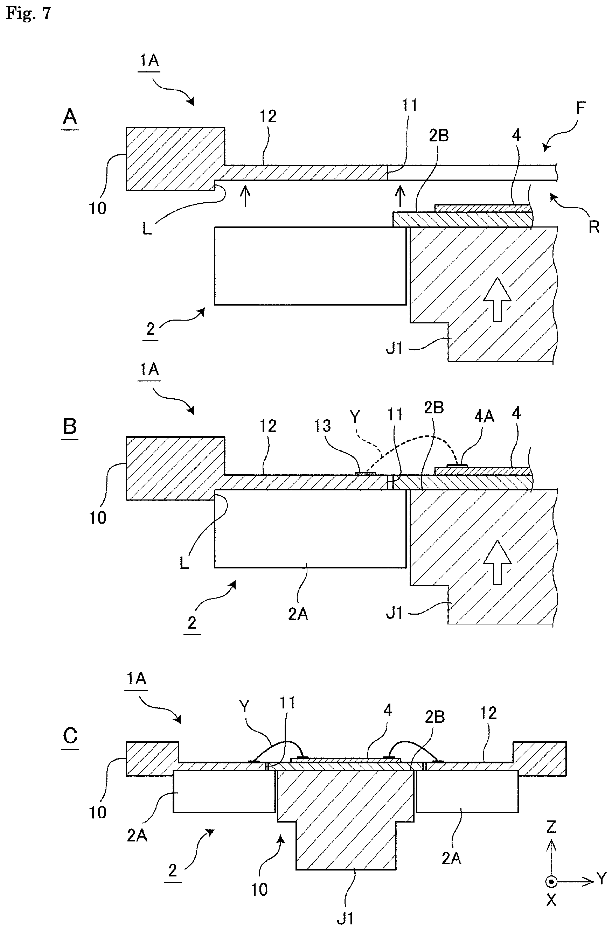

   Fig. 7A is a cross-sectional view showing the attachment state of a jig during die bonding to a lead frame, of an image sensor (semiconductor element) in the semiconductor device according to the first embodiment of the present disclosure, Fig. 7B is an enlarged cross-sectional view of the main part showing the state when the lead frame is attached to the package, and Fig. 7C is an enlarged cross-sectional view of the main part showing the situation when die bonding or wire bonding is performed after the lead frame is attached to the package.
[Fig. 8]

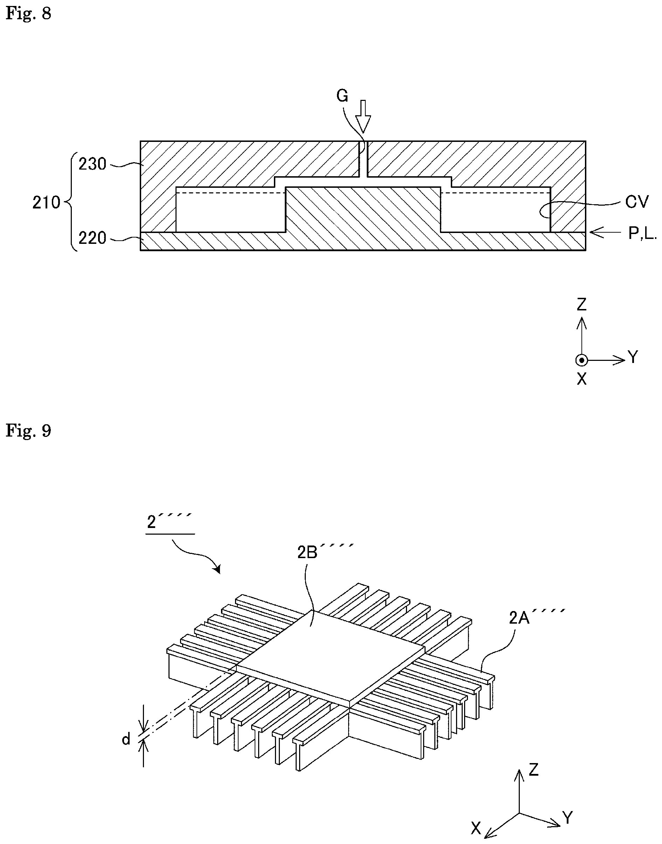

   Fig. 8 is a cross-sectional view showing a mold used for manufacturing a casting-type lead frame having a step, which is a modification of the lead frame according to the first embodiment of the present disclosure.
[Fig. 9]
   Fig. 9 is a perspective view showing a lead frame having a step formed by the mold shown in Fig. 8.
[Fig. 10]

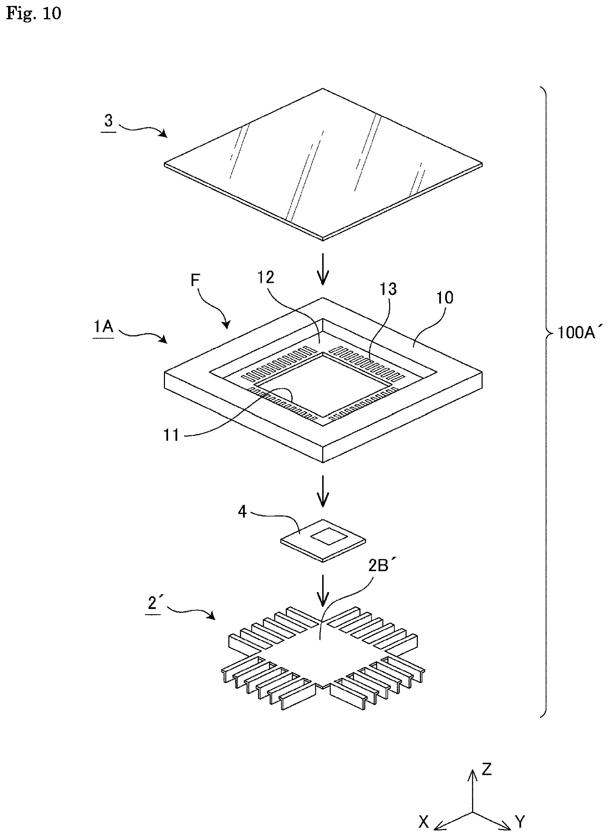

   Fig. 10 is an exploded perspective view showing a first modification of the first embodiment of the present disclosure.
[Fig. 11]

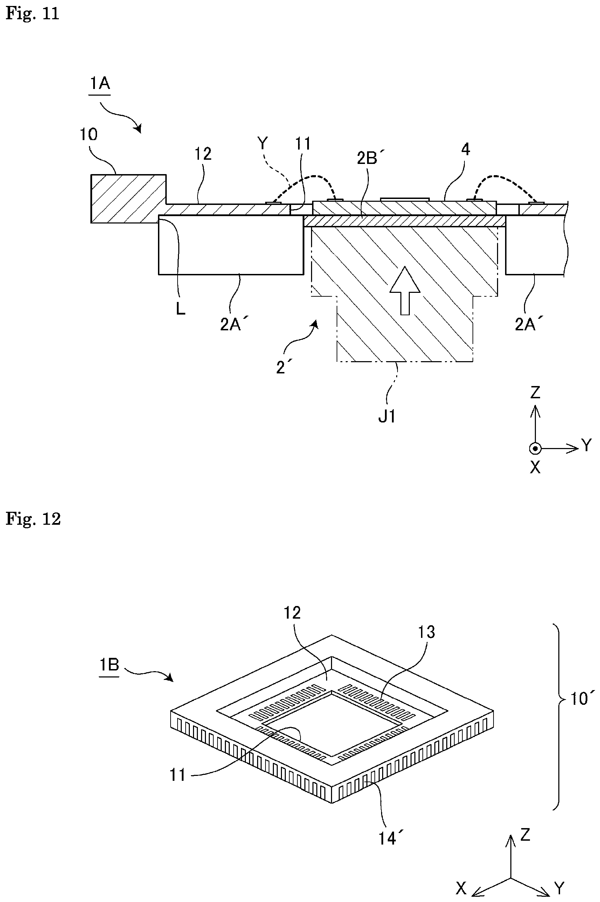

   Fig. 11 is an exploded perspective view showing the first modification of the first embodiment of the present disclosure when assembled.
[Fig. 12]
   Fig. 12 is a perspective view showing a second modification of the first embodiment of the present disclosure, showing a semiconductor device in which electrodes are provided on the side surface of the package.
[Fig. 13]

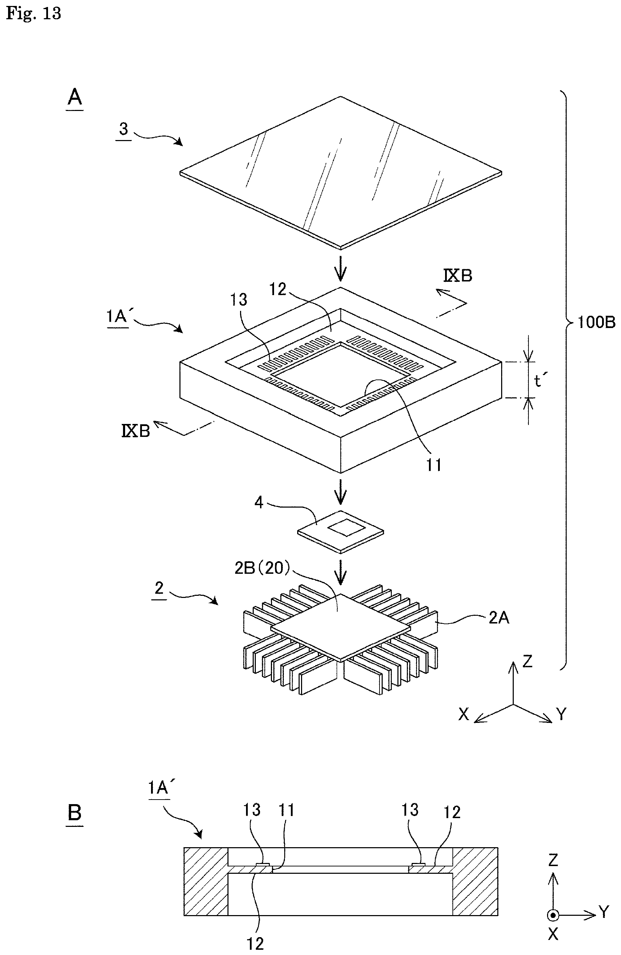

   Fig. 13A is an exploded perspective view showing a semiconductor device according to a second embodiment of the present disclosure, and Fig. 13B is a cross-sectional view taken along the line IXB-IXB in Fig. 13A.
[Fig. 14]

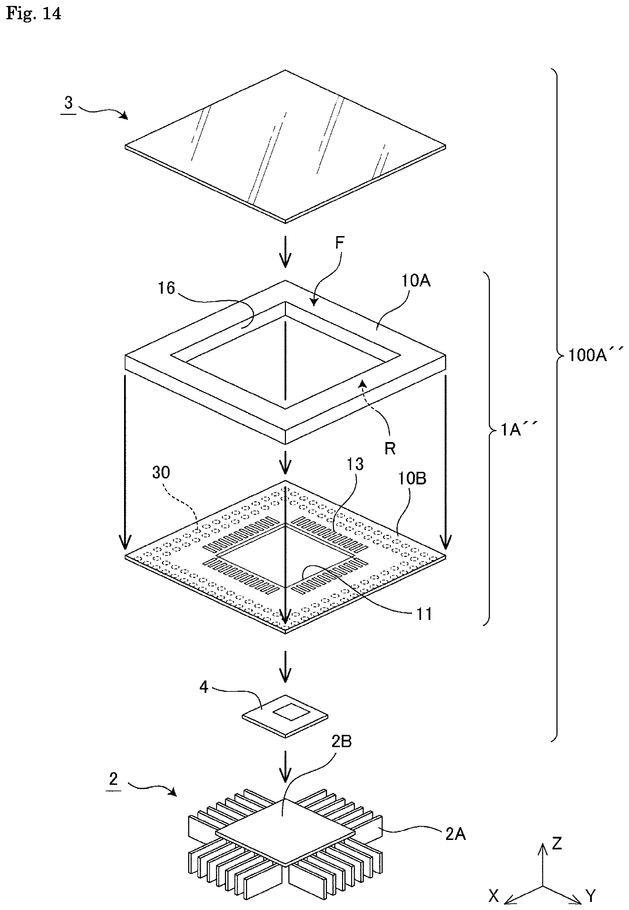

   Fig. 14 is an exploded perspective view showing a semiconductor device using an interposer in a package according to a third embodiment of the present disclosure.
[Fig. 15]

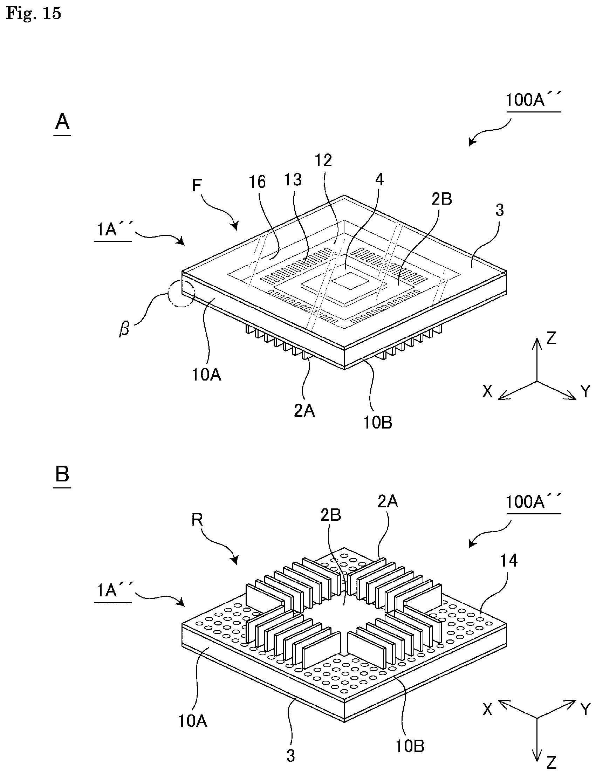

   Fig. 15A is a perspective view of the semiconductor device shown in Fig. 14 seen from above, and Fig. 15B is a perspective view of the device seen from below.
[Fig. 16]

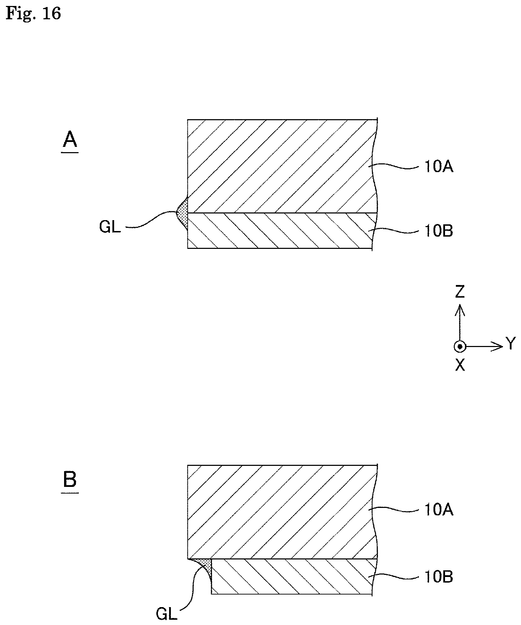

   Figs. 16A and 16B are enlarged explanatory views of the main parts showing the protruding state of the adhesive at the bonding site between the upper lid portion and the interposer, which is the β part of a semiconductor device using an interposer in the package according to the third embodiment of the present disclosure, in which Fig. 16A shows how the adhesive protrudes when their sizes are the same, and Fig. 16B shows how the adhesive protrudes when their sizes are slightly different.
[Fig. 17]

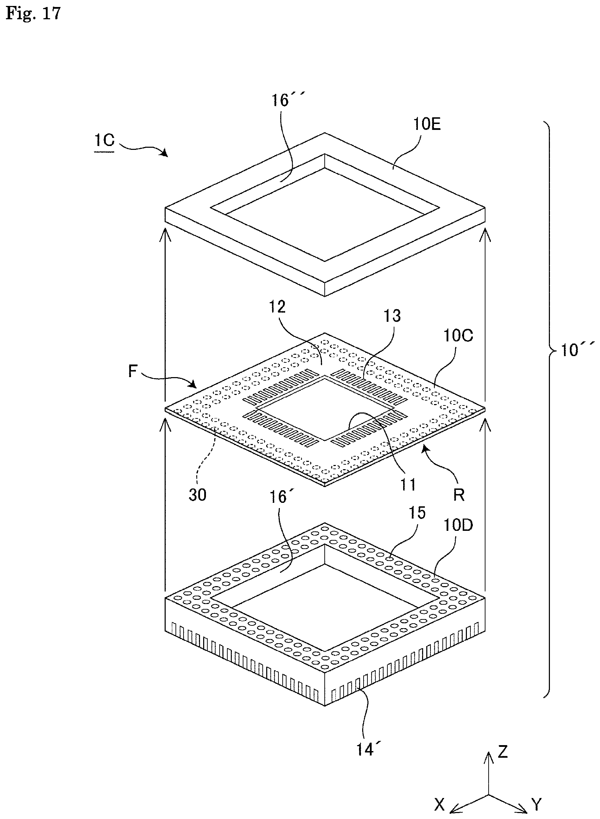

   Fig. 17 is an exploded perspective view showing a semiconductor device (excluding a cover glass) using a part of an interposer in a package according to a fourth embodiment of the present disclosure.
[Fig. 18]

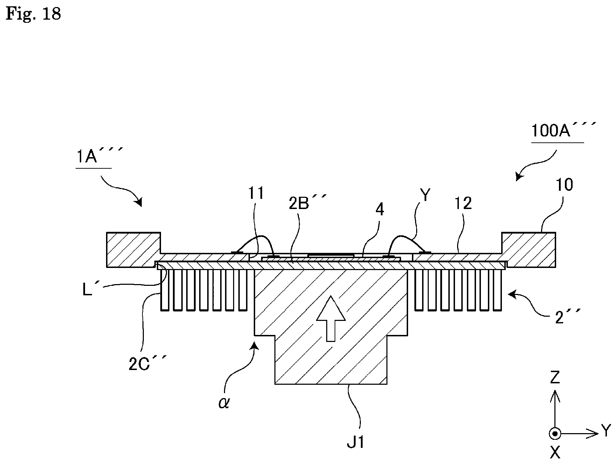

   Fig. 18 is a cross-sectional view showing how a semiconductor device according to a fifth embodiment of the present disclosure is manufactured using a dedicated jig.
[Fig. 19]

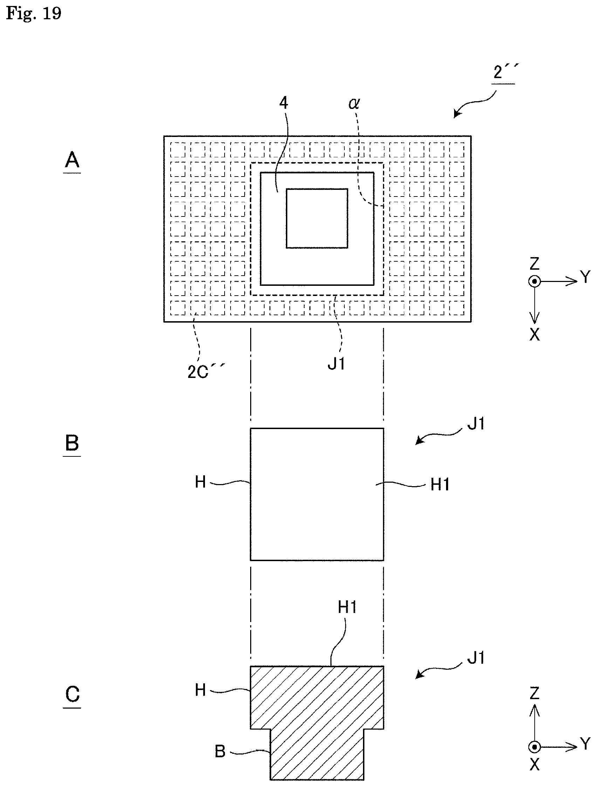

   Fig. 19A is a plan view showing the attachment state of a lead frame with a number of heat-dissipating pins used for manufacturing the semiconductor device shown in Fig. 18, an image sensor mounted on the lead frame, and a dedicated jig for die bonding for supporting the lead frame, Fig. 19B is a plan view showing a dedicated jig used when die bonding the image sensor to the lead frame of Fig. 19A, and Fig. 19C is a front view showing the dedicated jig.
[Fig. 20]

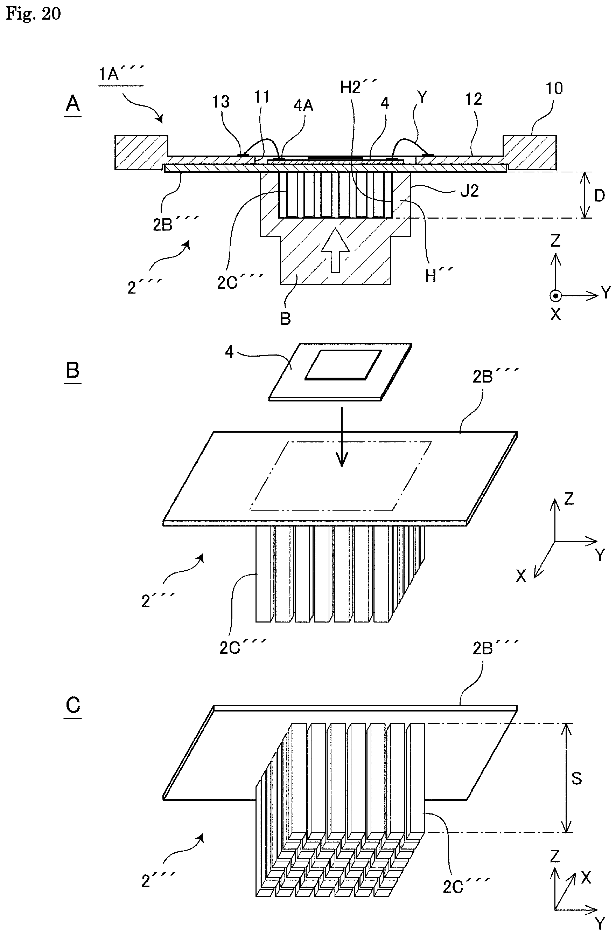

   Fig. 20A is a plan view showing the attachment state of a lead frame with a number of heat-dissipating pins on the center side used for manufacturing a semiconductor device, an image sensor mounted on the lead frame, and a dedicated jig for supporting the lead frame, Fig. 20B is a perspective view showing a state when an image sensor is mounted on the lead frame of Fig. 20A, and Fig. 20C is a perspective view showing a state when the lead frame is viewed from below.
[Fig. 21]

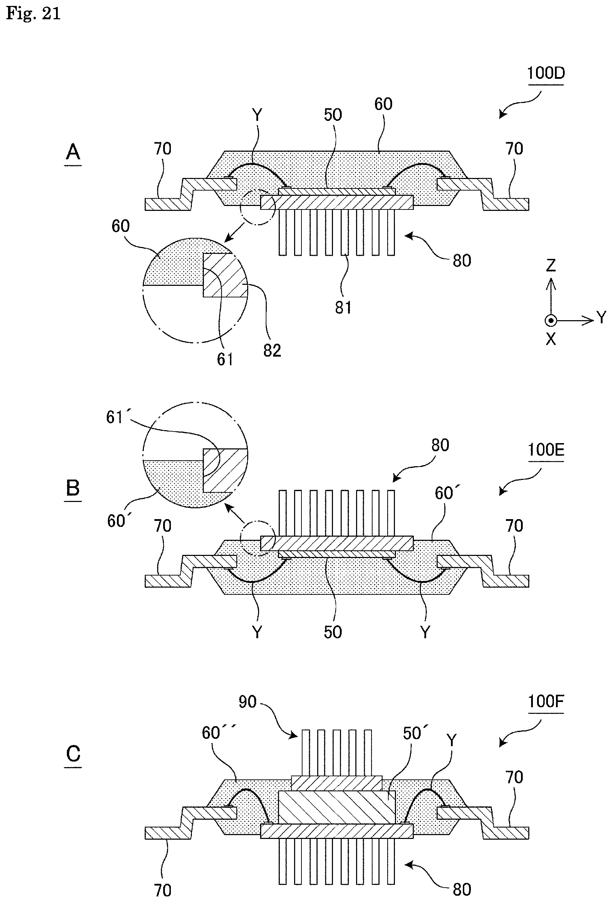

   Fig. 21A is a cross-sectional view showing a semiconductor device including a heat-dissipating lead frame at the bottom of a DIP according to a seventh embodiment of the present disclosure, Fig. 21B is a cross-sectional view showing a semiconductor device including the heat-dissipating lead frame at the top of the DIP, and Fig. 21C is a cross-sectional view showing a semiconductor device having the heat-dissipating lead frame at the bottom and the top of the DIP.
[Fig. 22]

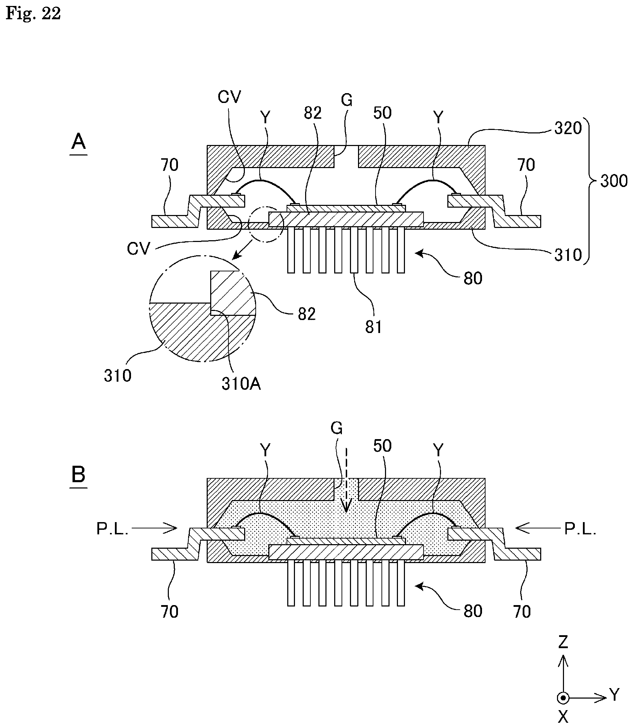

   Fig. 22 shows a method for manufacturing a semiconductor device according to an eighth embodiment of the present disclosure, in which Fig. 22A is a cross-sectional view showing a mold and the like used in the method for manufacturing the semiconductor device of the type shown in Fig. 21A, and Fig. 22B is an explanatory view showing the state when molding resin is poured into the mold shown in Fig. 22A.

### [Description of Embodiments]

Embodiments of the present disclosure and modifications thereof will be described in detail below with reference to the accompanying drawings.

The embodiments will be described in the following order.
1. First embodiment
   1) Configuration of semiconductor device (Figs. 1 to 6: welding-type lead frame is used)
   2) Method for manufacturing semiconductor device (Fig. 7: welding-type lead frame is used)
2. First modification of first embodiment (Figs. 10 and 11: punching-type lead frame is used)
3. Second modification of first embodiment (Fig. 12: modification of package)
4. Second embodiment (Fig. 13: concave area is formed on both sides of package)
5. Third embodiment (Figs. 14 and 15: interposer is used as substitute for ceramic package)
6. Fourth embodiment (Fig. 17: interposer is used in part of package)
7. Fifth embodiment (Figs. 18 and 19: semiconductor device is manufactured using casting-type lead frame and dedicated jig)
8. Sixth embodiment (Fig. 20: semiconductor device is manufactured using casting-type lead frame and one type of jig)
9. Seventh embodiment (Fig. 21: casting-type lead frame is applied to DIP-type semiconductor device)
10. Eighth embodiment (Fig. 22: Method for manufacturing semiconductor device according to seventh embodiment)

### <1. First embodiment>

### (Configuration of semiconductor device 100A)

Fig. 1 is an exploded perspective view showing a semiconductor device 100A according to a first embodiment of the present disclosure, Fig. 2A is a perspective view of the semiconductor device 100A seen from above, and Fig. 2B is a perspective view of the semiconductor device 100A seen from below. Note that in each of the following embodiments including the present embodiment, the right-handed Cartesian coordinates (X, Y, Z) are set for the three directions X, Y, and Z that are orthogonal to each other, but the origin is arbitrary and not specified.

The semiconductor device 100A of the present embodiment includes a semiconductor package 1A (hereinafter referred to as "package 1A"), a heat-dissipating lead frame 2 (hereinafter referred to as "lead frame 2"), and a cover glass 3, and an image sensor 4 which is a semiconductor element is mounted on the lead frame 2. Note that the lead frame 2 used in the present embodiment is a welding type (see Fig. 3), which will be described in detail later.

The package 1A of the present embodiment is formed of an LGA (Land Grid Array) type. That is, this package 1A is a package in which land-shaped planar electrodes (that is, pad electrodes 14 to be described later) are arranged at high density in a grid pattern on the bottom surface of the package 1A. Unlike a CSP (Chip Size Package) or the like, solder balls are eliminated so that the package can be made thinner. Further, this LGA-type package 1A can be electrically connected to a printed circuit board, for example, by using a socket or by directly soldering to the circuit board. Although this package 1A can be made of an inorganic or organic material, in the present embodiment, it is made of a resin frame made of an appropriate resin material (organic material).

In this package 1A, an opening 11 having a substantially square-shaped (or rectangular) shape is provided in the center of the front surface F of the main body 10 having a substantially square-shaped (or rectangular) shape. The heat-dissipating lead frame 2 according to the present embodiment is attached in a state of being inserted and fitted to the opening 11. Further, a cover glass 3 is attached to the open top portion of the front surface F of the package 1A.

Further, in the main body 10 of the package 1A, particularly on the front surface F, the peripheral area including the opening 11 forms a concave area 12 which is depressed by one step compared to the outer peripheral side. On the other hand, unlike the front surface F, the concave area 12 is not provided in the rear surface R of the main body 10, as shown in Fig. 2B. That is, the rear surface R of this main body 10 has a simple flat structure. In the central area of this rear surface R, which corresponds to the opening 11 on the front surface F side, a mounting portion 2B of the lead frame 2, which is provided with a heat-dissipating fin 2A constituting a heat-dissipating portion, is provided in a state of being inserted and fitted into the opening 11. The upper surface (see Fig. 2A) of this mounting portion 2B is exposed in a state of facing the concave area 12 on the front surface F of the package 1A. Note that in the semiconductor device of the present disclosure, a concave area similar to the concave area 12 on the front surface F may be provided on the rear surface of the main body, as will be described later. This will be described in detail in the second embodiment shown in Fig. 13.

In addition, in the present embodiment, for example, in the package 1A of Fig. 7, as shown in Fig. 7B, a slight notch L or the like is provided in the rear surface R of the main body 10 of the package 1A, although it is not deep enough to be called a concave area. Therefore, by locking a part of the fin 2A of the lead frame 2 (the upper side of the outer end surface) into the notch L, the positioning of the lead frame 2 with respect to the package can be simultaneously performed.

Furthermore, in Fig. 7, for example, in the concave area 12 on the front surface F of the main body 10, a number of pad electrodes 13 for achieving connection via wires Y (see Fig. 7A) are provided around the central opening 11, corresponding to pad electrodes 4A (see Fig. 7C) of the image sensor 4 disposed on the mounting surface 2B provided at the center of the front surface of the lead frame 2.

On the other hand, as shown in Fig. 2B, around the portion of the rear surface R of the main body 10 where the heat-dissipation fins 2A are arranged, a number of pad electrodes 14 electrically connected to the pad electrodes 13 on the front surface side of the main body 1 via internal wiring (not shown), via-holes, and the like in a manner that avoids the heat-dissipation fins 2A. With such a configuration, the semiconductor device 100A of the present embodiment is designed to electrically connect to the outside of the semiconductor device 100A via the pad electrodes 14 on the rear surface R side. The connection with the outside is not particularly limited to the use of the pad electrodes 14.

The lead frame 2 is made of a material that is easy to process and has heat dissipation properties, such as alloy 42, copper (Cu), and aluminum (Al). As shown in Fig. 1, the lead frame 2 has heat-dissipating fins 2Aprovided around it, and a substantially square-shaped (or rectangular) mounting portion 2B which is provided at the center on the front surface side of the main body 20, and on which the image sensor 4, which is a semiconductor element, is mounted. Note that, in order to further enhance the heat dissipation effect of the lead frame 2 of the present embodiment, the surface thereof may be coated with a paint using a metal pigment that has a heat dissipation effect. Moreover, when the package 1A is formed of a ceramic substrate, heat dissipation properties can be further improved by using an adhesive containing, for example, a metal filler.

Note that this pin-type lead frame 2 is not limited to the welding type described above. For example, a lead frame 2' having a shape as shown in Fig. 4B may be formed from a thin metal sheet 200 with high thermal conductivity and heat dissipation properties, as shown in Fig. 4A, by
1) first, cutting out the four corner areas 200A indicated by cross-hatching, for example,
2) cutting out the solid-line portions 200B, and
3) bending the solid-line portions 200B downward (or upward) at a right angle at the broken-line portions 200C.

In addition to the above-described two manufacturing methods, various methods for manufacturing this lead frame with heat-dissipating fins are possible. However, in the lead frame 2' (hereinafter referred to as the "punching type") formed by a punching method from one metal sheet with good thermal conductivity as shown in Fig. 4, a step (corresponding to the thickness of one metal sheet 200) is not formed between the surface of the mounting portion 2B' and a bent portion which is the upper end of the heat-dissipating fin 2A' as shown in Fig. 4B. In other words, it can be said that the heat-dissipating fins 2A' constituting the heat-dissipating portion are composed of a number of plate-shaped heat-dissipating fins formed around the mounting surface, which is the upper surface of the mounting portion 2B'. However, the heat-dissipating fins 2A' are arranged and formed facing downward, which is opposite to the mounting surface. Therefore, for example, in the manufacturing method shown in Fig. 7, when using this type, the mounting portion 2B' of the lead frame 2' cannot be exactly fitted into the opening 11 using the step as described above.

However, although the details will be described later, the package of the semiconductor device 100A' of the first modification shown in Fig. 10, which will be described later, is the same as the package 1A of the first embodiment shown in Fig. 7, and only the lead frame is different. That is, the only difference is that a punching-type lead frame 2' is used instead of the welding-type lead frame 2. Therefore, in the first modification described later, the mounting portion 2B' provided at the center of the lead frame 2' is not fitted into the opening 11 of the package 1A, as shown in Fig. 11, and is arranged directly under the opening 11 corresponding to the bottom of the opening 11.

Therefore, the image sensor 4, which is a semiconductor chip that is die-bonded to the surface (upper surface) of the mounting portion 2B', is arranged so as to fit inside of the opening 11 of the package or slightly protrude from the opening 11. Therefore, during wire bonding between the image sensor 4 and the package 1A side, wiring connection using the wires Y such as gold (Au) wires is possible without any particular problem.

Note that the welding-type lead frame shown in Fig. 3 used in Figs. 1 and 2 is more complicated to manufacture than the punching-type described above. However, as described above, since the mounting portion 2B can be fitted into the opening 11, it is preferable to use this type when considering the fact that the die bonding and wire bonding operations are easy and reliable.

In this welding-type lead frame 2, in a state where the mounting portion 2B is formed of a plate material with good thermal conductivity, and most of the heat-dissipating fins 2A are attached while protruding outward from the peripheral portion of the mounting portion 2B using a number of heat-dissipating fins 2A, which have been formed and prepared in advance, a part of the upper end surface of each heat-dissipating fin 2A is welded to the rear surface side of the mounting portion 2B to thereby form the lead frame 2.

In this way, according to the welding-type lead frame 2, a step d (corresponding to the thickness of one sheet, which is the thickness of the mounting portion 2B) is formed between the surface of the mounting portion 2B and the upper end surface of the heat-dissipating fin 2A. Therefore, in the case of using this welding type, as described above, if the step d is the same as the thickness of the concave area 12 of the package 1A, by fitting the mounting portion 2B' of the lead frame 2' into the opening 11 using the step d, the mounting portion 2B can be provided in the package 1A with the concave area 12 and the upper surface flush with each other.

Moreover, instead of the welding-type lead frame 2 or the punching type lead frame 2' formed by the method shown in Fig. 3 or 4, as shown in Fig. 5, for example, by pouring a molten material such as a metal with good thermal conductivity into a mold consisting of a pair of upper and lower parts and then cutting out the mold, a lead frame 2" (hereinafter referred to as a "casting type") may be formed in which heat-dissipating pins 2C" as a heat-dissipating portion are provided on the rear surface of the mounting portion 2B" as shown in Fig. 5.

In this casting-type lead frame 2", a number of quadrangular prism-shaped heat-dissipating pins 2C" constituting a heat-dissipating portion are formed on the rear surface side opposite to the front surface side of the mounting portion 2B" so as to protrude downward. Although the details will be described later, in the heat-dissipating pin 2C', a pin-free area α where the heat-dissipating pins 2C" are not disposed is formed on the center side of the rear surface of the lead frame 2", as shown in Fig. 5B. By providing this pin-free area α, a dedicated jig can be inserted into this pin-free area α.

That is, when the image sensor 4 is bonded and mounted on the mounting portion 2B" on the front surface side of the lead frame 2", a die bonder descends from above to die-bond the image sensor 4. For this reason, a space serving as a pressing area for a dedicated jig to support the lead frame 2" while facing the image sensor is required. Therefore, an area (pin-free area α) where the heat-dissipating pins 2C" are not provided is secured in the center on the rear surface of the lead frame 2" where a number of heat-dissipating pins 2C" are provided, corresponding to the mounting portion 2B".

The heat-dissipating pins 2C" of the casting type lead frame 2" of the present embodiment have a rectangular prism-shaped cross-section as shown in Fig. 5, the heat-dissipating pins 2C" are geometrically regularly arranged at equal intervals in the X, Y (front, rear, left, and right) directions like a grid pattern as shown in Fig. 6A, for example. Note that the heat-dissipating pins 2C" may be regularly arranged in a honeycomb shape, for example, as shown in Fig. 6B. Further, in the present disclosure, the heat-dissipating pin 2C" shown in Fig. 5 may have a rigid structure, and may be made of an alloy such as a somewhat soft material (for example, AlCu: copper aluminum). In particular, in the case of the latter heat-dissipating pins 2C" made of a soft material, adjacent heat-dissipating pins 2C" may be connected by a thin film body M as shown in Fig. 6A or 6B.

Further, the heat-dissipating pins may have a structure in which cylindrical heat-dissipating pins 2D" are regularly arranged in a grid pattern as shown in Fig. 6C, for example. Furthermore, the shape of the heat-dissipating pin of the present disclosure may be a triangular prism, a pentagonal prism, a hexagonal prism, or a polygonal prism having more polygons than these. Also in this case, the heat-dissipating pin 2D" may have a rigid structure, or may be made of a soft material. Also in this case, as shown in Fig. 6C, a configuration may be adopted in which adjacent heat-dissipating pins 2D" are connected by a thin film body M.

If this casting-type lead frame 2" is used, the lead frame 2" can be fitted into the opening 11 of the package 1A using the thickness of the mounting portion 2B", similarly to the welding-type lead frame 2 shown in Fig. 3. That is, unlike the punching-type, the upper end portions of the heat-dissipating pin 2C" and the heat-dissipating pin 2D" are not attached to the periphery of the end surface of the mounting portion 2B" of the lead frame 2 in a connected state. Thus, the mounting surface 2B" can be fitted into the opening 11 of the package 1A without being obstructed by the heat-dissipating pin 2C" or the heat-dissipating pin 2D".

Further, when molding a lead frame having a structure similar to the welding type shown in Fig. 5 by casting, for example, it is also possible to form a lead frame having a shape similar to the shape as shown in Fig 9 using a mold 210 as shown in Fig. 8, for example. The mold 210 shown in Fig. 8 is composed of a lower mold 220 and an upper mold 230, a gate G is formed in the upper mold 230, and a required material can be fed from the gate G into the cavity CV formed by the lower mold 220 and the upper mold 230. Thereafter, the cooled and solidified mold material is released from the parting line (P.L.) whereby a casting-type lead frame 2ʺʺ having a step d as shown in Fig. 9, which is a molded product can be formed.

That is, in this casting-type lead frame 2ʺʺ, the heat-dissipating fins 2Aʺʺ and the mounting portion 2Bʺʺ are only partially connected and integrated. In other words, the upper surface of the heat-dissipating fin 2A‴ʺ is flush with the lower surface of the mounting portion 2Bʺʺ, so that a step is formed between the mounting portion 2Bʺʺ and the heat-dissipating fin 2Aʺʺ.

Since the lead frame 2ʺʺ shown in Fig. 9 with such a structure has a step d like the welding type shown in Fig. 3, it becomes possible to fit the mounting portion 2Bʺʺ into the opening 11 of the package 1A using the step d, as shown in Fig. 7. Moreover, in the casting-type lead frame 2ʺʺ shown in Fig. 9, since the heat-dissipating fin 2Aʺʺ has a T-shaped vertical cross-section and the upper surface portion of the heat-dissipating fin 2Aʺʺ which is a portion integrated with the lower surface of the mounting portion 2Bʺʺ is formed wide, the Joule heat from the mounting portion 2Bʺʺ can be efficiently propagated. Moreover, in this lead frame 2ʺʺ, since the lower side of the heat-dissipating fins 2A‴ʺ except for the upper part has a narrow shape, it is possible to increase the heat dissipation efficiency by increasing the surface area accordingly. Since the amount of casting material can be reduced, it is also possible to reduce the cost.

The cover glass 3 is made of an appropriate material that is transparent and has a low attenuation rate of transmitted light, and is bonded with an appropriate resin to seal the concave area 12 on the surface of the package 1A. Thus, the image sensor 4 provided inside of the concave area 12 is protected from dust, moisture, or the like from the outside.

The image sensor 4 is not limited to a CMOS (complementary metal-oxide semiconductor) as in the present embodiment, but may be applied to a CCD (charge coupled device) or other devices.

### (Method for assembling semiconductor device 100A)

Next, a method for manufacturing the semiconductor device 100A according to the first embodiment of the present disclosure will be described with reference to Fig. 7. Note that the lead frame used here is the welding-type lead frame 2 shown in Fig. 3.

During this assembly, the image sensor 4, which is a semiconductor element, is already mounted on the surface of the mounting portion 2B of the lead frame 2 by a die bonder (not shown). After the lead frame 2 is fitted and attached to the rear surface R of the package 1A, the image sensor 4 may be mounted on the surface of the mounting portion 2B of the lead frame 2.

Fig. 7A is a schematic cross-sectional view showing a manufacturing method when attaching the welding-type heat-dissipating lead frame 2 shown in Fig. 3 to a package 1A similar to that used in the semiconductor device 100A of the present embodiment shown in Fig. 1, for example, and the method is performed using a dedicated jig J1.
1) First, the mounting portion 2B of the lead frame 2 is inserted and fitted from the rear surface R side of the package 1A as shown in Fig. 7A, that is, so that the mounting portion 2B of the pinned lead frame 2 fits into the opening 11 provided in the concave area 12 on the front surface F side of the package 1A. In this case, as described above, by locking a part (upper part) of the fins 2A of the lead frame 2 to the notch L of the rear surface R of the package 1A, the positioning of the lead frame 2 with respect to the package 1A can be simultaneously performed. In this way, the mounting portion 2B of the lead frame 2 can be easily fitted into the opening 11 of the package 1A.
   In addition, in the present embodiment, the operation of inserting and fitting the lead frame 2 into the package 1A is also performed using the dedicated jig J1 for supporting the lead frame from below during wire bonding. That is, the jig J1 is inserted in advance into the area (pin-free area α) where the heat-dissipating fins 2A are not provided, on the lower surface side of the lead frame 2, which is directly under the surface of the mounting portion 2B of the lead frame 2 so that the mounting portion 2B at the center of the lead frame 2 and its surroundings are supported from below by the jig J1. In particular, this insertion/fitting operation may be performed using an appropriate means other than the jig J1.
2) In this way, as shown in Fig. 7B, when the mounting portion 2B of the lead frame 2 is fitted into the opening 11 of the package 1A, the mounting portion 2B at the center of the lead frame 2 and its surroundings are supported from below using the jig J1 inserted into the area (pin-free area α) where the heat-dissipating fins 2A are not provided, on the lower surface side of the lead frame 2, which is directly under the surface of the mounting portion 2B of the lead frame 2.
3) By supporting the lead frame 2 from below in this way, the package 1A is also supported from below at the same time. Thereafter, the pad electrode 4A on the image sensor 4 side and the pad electrode 13 on the package 1A side are connected by a wire bonder (not shown) or the like using wires Y such as gold (Au) wires. At this time, the wire bonding can be performed reliably without the heat-dissipating fins 2A of the lead frame 2 getting in the way and preventing the lead frame 2 from being properly supported.

### <2. First modification of first embodiment>

Next, a first modification of the semiconductor device of the first embodiment will be described in detail with reference to Fig. 10. In the semiconductor device 100A' of the present embodiment, the same parts as in the first embodiment are given the same reference numerals to avoid redundant explanation.

### (Configuration of semiconductor device 100A')

In the first modification shown in Fig. 10, unlike the first embodiment, a punching-type lead frame 2' shown in Fig. 4 is used as the lead frame. However, since the same package 1A as in the first embodiment is used in this first modification, as shown in Fig. 11, a recess L is provided on the rear surface R side.

According to this modification, since a punching-type lead frame 2' is used, the upper surface of the heat-dissipating fins 2A' around the mounting portion 2B' of the lead frame 2' is flush with the surface (upper surface) of the mounting portion 2B', and the mounting portion 2B does not protrude beyond the upper surface of the heat-dissipating fin 2A'. Therefore, although the mounting portion 2B' of the lead frame 2' cannot be inserted or fitted into the opening 11 of the package 1A, as shown in Fig. 11, the mounting portion 2B' does not fit into the opening 11 of the package 1A but the image sensor 4 die-bonded to the mounting portion 2B' fits into the opening 11 by at least this thickness.

As a result, although it depends on the thickness of the image sensor 4, the level difference between the floor surface of the concave area 12 of the package 1A and the upper surface of the image sensor 4 can be reduced. As a result, when connecting the wires Y by wire bonding between the pad electrode of the package 1A and the pad electrode of the image sensor 4, decrease in operation efficiency due to the level difference between the floor surface of the concave area 12 of the package 1A and the upper surface of the image sensor 4 can be avoided.

### <3. Second modification of first embodiment>

Next, a second modification of the semiconductor device of the first embodiment will be described in detail with reference to Fig. 12. In the present embodiment, the same parts as in the first embodiment are given the same reference numerals to avoid redundant explanation.

### (Configuration of package 1B)

In the semiconductor device of the present embodiment shown in Fig. 12, instead of the element 14 (see Fig. 2B) on the rear surface side of the main body 10 of a LAG (Land Grid Array)-type package 1A like the first embodiment, an electrode 14' is formed on the outer end surface of the main body 10' of the package 1B as an element for electrical connection with the outside of the semiconductor device. Note that even in the case of the present embodiment, an electrode may be further provided on the rear surface side of the main body 10' of the package 1B in addition to the electrode 14' on the outer end surface of the main body 10' of the package 1B.

The electrode 14' is electrically connected to the pad electrode 13 formed so as to surround the edge of the opening 11 of the concave area 12 on the surface of the package 1B using internal wiring (not shown) provided inside of the package 1B.

Therefore, according to the present embodiment, since the wiring connection between the semiconductor device of the present embodiment and the outside can be realized from the electrode 14' on the outer end surface side of the package 1B, the connection operation becomes easier than that of the first embodiment, and the subsequent inspection and replacement in the event of a failure become easier.

### <4. Second embodiment>

Next, a second embodiment will be described with reference to Fig. 13. In the present embodiment, the same parts as in the first embodiment are given the same reference numerals to avoid redundant explanation.

### (Configuration of semiconductor device 100B)

The semiconductor device 100B of the present embodiment shown in Fig. 13 is different from the semiconductor device 100A of the first embodiment in that a concave area is formed on both the front and rear surfaces of the package 1A', unlike the package 1A of the first embodiment. That is, in the present embodiment, as shown in Fig. 13B, not only the concave area 12 is provided on the front surface of the package 1A' of the semiconductor device 100B, but also the concave area 12 is formed on the rear surface of the package 1A'.

As described above, since the concave area is provided on both the front and rear surfaces of the package 1A', the thickness t' is significantly increased compared to the thickness t of the package 1A of the first embodiment (t<<t').

Therefore, according to the present embodiment, for example, since the fin 2A of the lead frame 2 can be completely (or partially) stored in the concave area 12 on the rear surface side of the package 1A', assembly into a desired product becomes easy, and the attachment stability after assembly is also improved.

### <5. Third embodiment>

Next, a third embodiment will be described with reference to Figs. 14 and 15. In the present embodiment, the same parts as in the first embodiment are given the same reference numerals to avoid redundant explanation.

### (Configuration of semiconductor device 100A")

The semiconductor device 100A" of the present embodiment differs from the semiconductor device 100A of the first embodiment in that the package 1A" is partially composed of an interposer. Specifically, this semiconductor device 100A" is composed of an upper lid body 10A and an interposer body 10B. Note that the heat-dissipating lead frame 2 and the cover glass 3 have the same configuration as in the first embodiment. In particular, the lead frame 2 is of a welding type, but is of course not limited to this type, and may be of a punching-type or a casting type.

The upper lid body 10A is formed by layering many sheets made of organic materials, and a square-shaped (or rectangular) large opening 16 is provided at the center in order to form a space (cavity) for connecting wires by wire bonding or the like (the space later becomes the concave area 12 shown in Fig. 15A). Further, the upper lid body 10A may be of a casting type formed to a desired thickness using a mold, for example. Furthermore, the upper lid body may be formed by a 3D printer, for example, in addition to injection molding using a mold.

The large opening 16 is at least larger in size than the opening 11 of the interposer body 10B. When these two bodies, that is, the upper lid body 10A and the interposer body 10B are joined, an area which is the portion corresponding to the difference in size between this large opening 16 and the opening 11 of the interposer body 10B is exposed as a bottom surface portion on the front surface F side of the package 1A". That is, by joining and integrating the upper lid body 10A and the interposer body 10B, a space defined by the bottom part on the front surface F side of the package 1A" and the upper lid body 10A becomes the concave area 12 as shown in Fig. 15A.

On the other hand, the interposer body 10B has the same external size as the upper lid portion 10A, and is integrally fixed to the rear surface R side of the package main body. Further, this interposer body 10B is provided with a square-shaped (or rectangular) opening 11 in the center. Furthermore, a pad electrode 13 is formed around the opening 11 on the front surface F side of this interposer body 10B, and a pad electrode 14 (or BGA (ball grid array) such as solder ball) is formed on the rear surface R side of this interposer body 10B. The pad electrode 13 on the front surface F side and the pad electrode 14 on the rear surface side are electrically connected by internal wiring (not shown) or the like.

In the present embodiment, as described above, the interposer body 10B is formed so that the external size is the same as that of the upper lid portion 10A, as shown in Fig. 15. That is, as shown in Fig. 16A, the upper lid portion 10A and the interposer 16B are formed to have the same dimensions. Therefore, when the lid portion 10A and the interposer 16B are bonded and joined together, the adhesive GL protrudes from the bonding surface and bulges out, forming a protruding part such as a protrusion, which may be exposed to the outside and remain there as it is.

Therefore, as shown in Fig. 16B, the interposer 10B may be formed to have a slightly smaller size than the upper lid portion 10A. In other words, the upper lid portion 10A and the interposer 16B may have a step formed in a portion where the surfaces thereof are bonded together. Alternatively, the interposer 10B may be formed to have a slightly larger dimension than the upper lid portion 10A.

For example, when the structure as shown in Fig. 16B is employed, even if the adhesive G protruding from the bonded area moves from the inside of the bonded area to the outside, the protruding adhesive GL can remain within the area up to the end of the bonding surface due to surface tension, intermolecular force, or other tensile action, for example. At this time, the protruding adhesive GL usually forms a curved surface such as a smooth quadratic curve with an arcuate cross-sectional shape in the area up to the end of the bonding surfaces, and it becomes possible to improve smoothness and flatness in the step portion.

Therefore, according to the semiconductor device 100A" of the present embodiment, it is possible to easily manufacture a package 1A" which is a type in which an interposer is partially provided and the concave area 12 is provided on the front surface F side. Even in the semiconductor device 100A" having such a configuration, the image sensor 4 constituting a semiconductor chip can be die-bonded to the mounting portion 2B of the lead frame 2 fitted to the opening 11 on the front surface side of the interposer body 10B facing the concave area 12 using a die bonder, similarly to the package 1A shown in Figs. 1 and 2. Similarly, the pad electrode 13 provided on the concave area 12 on the front surface F side of the package 1A", that is, the front surface side of the interposer body 10B, and the pad electrode (not shown) on the image sensor 4 side can be reliably electrically connected using wires such as gold (Au) wires.

Moreover, even if the upper lid portion 10A and the interposer body 10B are not formed in such a way that the sizes are exactly matched with high precision, as shown in Fig. 16, if the adhesive GL protrudes from the bonding areas, a smooth curved surface shape is formed that absorbs the step caused by the difference in size due to the action of surface tension or the like. This makes it possible to compensate for the difference in size. Therefore, since high processing precision is not required for the upper lid portion 10A and the interposer body 10B, it is possible to reduce costs accordingly.

### <6. Fourth embodiment>

Next, a fourth embodiment will be described with reference to Fig. 17. In the present embodiment, the same parts as in the first embodiment are given the same reference numerals to avoid redundant explanation.

### (Configuration of package 1C)

In the semiconductor device of the present embodiment shown in Fig. 17, unlike the first embodiment, a main body 10" of a package 1C includes an intermediate frame 10C, a lower half body 10D, and an upper half body 10E forming an interposer substrate. These three bodies are stacked one on top of the other and fixed together with an adhesive or other appropriate means.

The intermediate frame 10C has a substantially square-shaped (or rectangular) opening 11 having the same shape and size as that of the first embodiment, and On the front surface F of this intermediate frame 10C, pad electrodes 13 similar to those of the first embodiment are provided in peripheral portions facing the four sides of the opening 11. Further, a BGA (ball grid array) 30 is provided on the rear surface R of the intermediate frame 10C, and a through-electrode (not shown) or the like is formed inside of the intermediate frame 10C in order to electrically connect with the pad electrode 13 on the front surface side.

Although the BGA is provided on the rear surface of the intermediate frame 10C in the present embodiment, it may also be an LGA (Land Grid Array) in which lands are arranged in a grid on the bottom surface of the package. When this LGA is used, since the parasitic inductance of the terminal is small, it is suitable for high-speed, high-frequency operation, and unlike a BGA (Ball Grid Array), it can be mounted using a socket or the like.

The lower half body 10D and the upper half body 10E can be made of an organic substrate or an inorganic substrate. In the present embodiment, the lower half body 10D and the upper half body 10E are composed of a plurality of layers obtained by stacking layers formed of a suitable organic material, such as a thermosetting epoxy resin such as a glass epoxy substrate or a glass composite substrate. Further, as another method for forming the lower half body 10D and the upper half body 10E, the bodies may be of a casting type in which they are formed to a desired thickness (height) using a mold.

In particular, both the lower half body 10D and the upper half body 10E have the same outer shape and dimensions as the intermediate frame 10C, but the bodies are formed in an approximately square shape with a square-shaped (or rectangular) opening at the center. Further, the openings provided in the lower half body 10D and the upper half body 10E, that is, the large opening 16' and the large opening 16", respectively, are larger than the opening 11 of the intermediate frame 10C, which is an interposer. When these three bodies are stacked and integrated to complete the package 1C, a space serving as a concave area is formed on both the front and rear surface sides of the main body 10".

In particular, this lower half body 10D is provided with a pad electrode 15 that is electrically connected to the BGA 30 on the rear surface of the intermediate frame 10C. Further, in the lower half body 10C of the present embodiment, similarly to the electrode 14' provided in the second modification of the first embodiment shown in Fig. 11, an electrode 14' is provided which is connected to the pad electrode 15 by internal wiring (not shown).

Therefore, according to the package 1C of the present embodiment, it is easy to manufacture the package 1C of the type in which the concave area is provided on both the front and rear surfaces, and it is also possible to reduce costs.

### <7. Fifth embodiment>

Next, a fifth embodiment will be described with reference to Figs. 18 and 19. In the present embodiment, the same parts as in the first embodiment are given the same reference numerals to avoid redundant explanation.

Fig. 18 illustrates a method for assembling the image sensor 4 in a semiconductor device 100A‴ having a lead frame 2" provided with a heat-dissipating pin 2C" according to the present embodiment.

### (Configuration of semiconductor device 100")

First, the configuration of the semiconductor device of the present embodiment will be described.

The semiconductor device 100A‴ of the present embodiment shown in Fig. 18 differs from the semiconductor device 100A of the first embodiment shown in Fig. 7 in that the lead frame is not a welding type but a casting type as shown in Fig. 5. Unlike the welding-type lead frame 2 shown in Fig. 3, in this casting-type lead frame 2", as shown in Fig. 5, the upper surface of the mounting surface 2B" is enlarged to cover almost the entire surface up to the attachment part of the heat-dissipating pin 2C", and no step is formed on the upper surface side similarly to the punching-type lead frame 2' shown in Fig. 4. Therefore, in the semiconductor device 100A‴ of the present embodiment, as shown in Fig. 18, a notch L' whose length is at least equal to the entire length of the lead frame 2" is provided on the back surface of the package 1A‴.

The shape of this notch L' is the same as that of the package 1A of the first embodiment shown in Fig. 7. In the first embodiment, the mounting portion 2B of the lead frame 2 enters into the opening 11 of the package 1A. On the other hand, in the lead frame 2" of the present embodiment, the entire front surface of the mounting portion 2B" comes into contact with the notch L' of the package 1A" in an engaging state to seal the opening 11 from the bottom side.

### (Operation such as assembly of semiconductor device 100‴)

In this assembly operation, the assembly and mounting operation of the image sensor 4 and the operation of attaching the wires Y such as gold (Au) wires are performed using a dedicated jig J1 as a supporting jig (collet) during die bonding to the lead frame 2" shown in Fig. 19.

As described above, in the fifth embodiment, as shown in Fig. 5, a casting-type lead frame 2" in which a heat-dissipating pin 2C" is formed on the rear surface of a mounting portion 2B" is used as the lead frame, and a pin-free area α is formed on the center side of the rear surface. Note that the lead frame used in the present embodiment is not particularly limited to this type, and may be a welding-type or punching-type lead frame.

### (Structure of dedicated jig J1)

The dedicated jig J1 is configured to support the mounting surface provided at the center of the surface of the mounting portion 2B" of the lead frame 2" on which the image sensor 4 is mounted when the image sensor 4 is die-bonded to the lead frame 2" by pressing against the pin-free area α provided at the center on the rear surface side of the mounting surface, which is directly below the mounting surface. At the same time, this dedicated jig J1 can also stably hold the package 1A", in which the lead frame 2" is attached to the rear surface side, via the lead frame 2". As shown in Figs. 18 and 19, the dedicated jig J1 of the present embodiment has a substantially T-shaped vertical cross-section, and is firmly set on, for example, a base which is not shown.

That is, the dedicated jig J1 for die bonding of the present embodiment is composed of an upper head H and a lower base B, as shown in Fig. 19. The head H has a flat upper surface H1, and has a size to cover the entire surface of the mounting surface of the lead frame 2", including at least the area where the image sensor 4 can be mounted. With the dedicated jig J1 having such a configuration, the head H can press against the pin-free area α on the rear surface of the mounting surface, and can reliably support the mounting surface in a stable state.

A die collet 2B, which has attracted the image sensor 4, descends from above the mounting surface of the mounting portion 2B", which is stably held in this state, and the image sensor 4 is fixed by attraction. In this case, for example, if the package 1A is an inorganic substrate made of ceramic or the like, the lead frame 2" on which the image sensor 4 is mounted is inserted from the rear surface side of the package 1A", and then only the image sensor 4 that has passed through the opening 11 pops out from the opening 11 to the upper surface. In this way, the package 1A‴, which is an inorganic substrate, can be attached by soldering or adhesive. Note that even if the package 1A is an organic substrate made of an organic material, it can be similarly attached by soldering or adhesive.

Therefore, according to the present embodiment, the image sensor 4 and the wires Y can be reliably attached using only the dedicated jig J1 during the die bonding and wire bonding operations. As a result, these operations can be performed reliably and stably.

### <8. Sixth embodiment>

Next, the sixth embodiment will be described in detail with reference to Fig. 20. In the present embodiment, the same parts as in the first embodiment are given the same reference numerals to avoid redundant explanation.

### (Configuration of lead frame 2‴)

In manufacturing the semiconductor device package in the present embodiment, a package 1A‴ similar to that in the fifth embodiment is used. Further, the lead frame attached to this package 1A‴ is of a casting type, but even if it is of this casting type, in the present embodiment, in the present embodiment, unlike the configuration shown in Fig. 5, the lead frame 2" is used having a configuration in which the pin-free area α is formed not on the center side but on the outer edge side, as shown in Figs. 20B and 20C.

### (Structure of dedicated jig J2)

For this reason, a dedicated jig J2 is used that corresponds to the shape of the lead frame 2‴ to be used. Note that, as described above, the same package as the package 1A‴ of the fifth embodiment is used.

As shown in Fig. 20A, the lead frame 2‴ used in the present embodiment has a shape in which a mounting portion 2B‴ extends in the XY direction, as in the fifth embodiment. As shown in Fig. 20C, a heat-dissipating pin 2C‴ is formed only in the center of this mounting portion 2"'.

On the other hand, as described above, the dedicated jig J2 shown in Fig. 20A has a configuration that corresponds to the lead frame 2"'. That is, this dedicated jig J2 shown in Fig. 20A has a configuration including a substantially square-shaped head H" and a base B. In particular, the recess H2" of the head H" of this dedicated jig J2 is formed such that the entire lead frame 2" fits into the opening, and this recess H2" is formed so that the depth D is the same or approximately the same as the length S (see Fig. 20C) of the heat-dissipating pin 2C", that is, D=S or D≒S.

Therefore, the dedicated jig J2 having such a configuration can be used not only for wire bonding with the wires Y such as gold (Au) wires, but also for die bonding of the image sensor 4. That is, as shown in Fig. 20A, the dedicated jig J2 can apply supporting force corresponding to the pressing operation with the wire bonder and the die bonder in the mounting operation of the image sensor 4 or the wiring operation using the wires Y to substantially the entire area of the lead frame 2"'.

In other words, when mounting the image sensor 4 to the center of the upper surface of the mounting portion 2B‴ of the lead frame 2‴ using a die bonder, as shown in Fig. 20A, the lower end surface of each heat-dissipating pin 2C‴ comes into contact with the bottom surface of the recess H2" of the dedicated jig J2. As a result, the lead frame 2‴ can be reliably supported on the mounting portion 2B‴.

In addition, when wiring the wires Y using gold (Au) wires or the like between the pad electrode 4A of the image sensor 4 and the pad electrode 13 provided in the concave area 12 of the package 1A‴, the wire bonder for wiring connection between the pad electrode 4A and the pad electrode 13 is pressed against these pad electrodes from above via the wires Y. On the other hand, on the rear surface side of the lead frame 2‴, as shown in Fig. 20A, the lower end surface of each heat-dissipating pin 2C‴ is in contact with the bottom surface of the recess H2" of the head H" of the dedicated jig J2, which opposes the pressed portion by the wire bonder from the opposite side. Therefore, in addition to directly pressing the upper end surface of the head H" of the dedicated jig J2 against the rear surface of the lead frame 2", the lower end surface of each heat-dissipating pin 2C" is pressed against the bottom surface of the recess H2" of the dedicated jig J2, whereby the package 1A‴ can be reliably supported on the mounting portion 2B‴ with the heat-dissipating pin 2C‴ interposed therebetween.

Therefore, according to the dedicated jig J2 of the present embodiment, by using the dedicated jig J2 that also serves as these dedicated jigs during die bonding and wire bonding operations, the attachment operation of the image sensor 4 and the wires Y can be carried out reliably. In other words, these operations can be performed reliably and stably using only one type of dedicated jig J2.

### <9. Seventh embodiment>

Next, the semiconductor device of the present disclosure can be applied to various types of packages for general semiconductors, for example, a DIP (Dual Inline Package)-type package as shown in Fig. 21.

### (I) (Configuration in semiconductor device 100D)

That is, a semiconductor device 100D according to the seventh embodiment of the present disclosure shown in Fig. 21A uses a package 60 of the above-described DIP type. In this DIP-type package 60, a plurality of lead pins 70 are provided to protrude in the lateral (Y) direction from both sides of the long side of the package 60, and a heat-dissipating lead frame 80 having a number of heat-dissipating pins 81, similar to that shown in Fig. 5, is attached to the bottom of the package 60 in a protruding state.

In particular, as shown in the enlarged view of the main part in Fig. 21A, a stepped portion 61 into which the upper surface side of the main body portion 82 of the lead frame 80 fits is formed on a part of the bottom side of the package 60, and the stepped portion has dimensions corresponding to the size of the main body portion 82.

On the other hand, the lead frame 80 is of a casting-type as shown in Fig. 5, and similarly to the lead frame shown in Fig. 5, a pin-free area α is formed in the center, and a dedicated jig having the same configuration as the dedicated jig J1 shown in Figs. 18 and 19 can be inserted into this pin-free area α.

Therefore, according to the semiconductor device 100D of the present embodiment, even if the package 60 accommodates the semiconductor chip 50 with high heat generation as a semiconductor element, the heat-dissipating lead frame 80 can efficiently dissipate heat to the outside of the package 60. That is, according to the semiconductor device 100D of the present embodiment, when a large amount of Joule heat is generated from the semiconductor chip 50 mounted on the mounting portion of the lead frame 80, the heat can be directly dissipated to the outside from the heat-dissipating pin 81 integrated to the rear surface side via the rear surface of the main body portion 82 immediately below the upper surface of the mounting portion provided on the central side of the main body portion 82 of the lead frame 80 having the semiconductor chip 50 mounted thereon.

### (II) (Configuration in semiconductor device 100E)

Further, a semiconductor device 100E shown in Fig. 21B uses the DIP-type package 60 like the semiconductor device 100D shown in Fig. 21A, and the lead pins 70 are attached to this package 60' in an upside-down state compared to the package 60 shown in Fig. 21A. In this manner, in this semiconductor device 100E, die bonding and wire bonding can be performed upside down. In addition, when performing these bonding operations, if a jig is set in the pin-free area on the center side where parts of the heat-dissipating pins 81 are missing, these bonding operations can be performed reliably.

Therefore, according to the semiconductor device 100E of the present embodiment, unlike the semiconductor device 100D, heat can be effectively dissipated upward from the semiconductor device 100E through the heat-dissipating lead frame 80 provided on the upper surface side of the package 60'.

### (III) (Configuration in semiconductor device 100F)

Next, in a semiconductor device 100F shown in Fig. 21C, a lead frame 80 similar to that of the semiconductor device 100D shown in Fig. 21A is provided on the lower side of the DIP-type package 60". A lead frame 90, which is slightly smaller than the lead frame 80 shown in Fig. 21B, is attached. Further, in this semiconductor device 100F, a power transistor 50' such as a power MOSFET (Metal-Oxide-Semiconductor-Field-Effect-Transistor) is accommodated as a semiconductor element that generates more heat than the semiconductor chip 50. The transistor 50' has its lower surface in contact with the upper surface of the main body mounting portion of the lead frame 80 on the lower side of the package 60", and has its upper surface in contact with the lower surface of the main body mounting portion of the lead frame 90 on the upper side of the package 60".

Therefore, according to the present embodiment, even if a high-power transistor is mounted in a DIP-type package, it is possible to efficiently dissipate heat.

### <10. Eighth embodiment>

Next, an eighth embodiment according to the present disclosure will be described in detail with reference to Fig. 22. In the present embodiment, the same parts as in the seventh embodiment are given the same reference numerals to avoid redundant explanation.

Fig. 22A is a cross-sectional view showing a mold and the like for manufacturing the semiconductor device 100D (Fig. 21A) of the seventh embodiment. In the semiconductor device 100D of the seventh embodiment, the portion corresponding to the package 60 can be manufactured by a mold apparatus 300 of the present embodiment, which includes a lower mold 310 and an upper mold 320.

That is, in the present embodiment, first, the heat-dissipating lead frame 80 and the lead pins 70 are set inside of the lower mold 310. Note that the semiconductor chip 50 may be mounted on the lead frame 80 in advance, or may be die-bonded at this stage. Further, connection wiring between electrodes (not shown) on the semiconductor chip 50 side and the lead pins 70 can be made using bonding wires at this stage.

After the lead pins 70 and the semiconductor chip 50 are set in the lower mold 310 in this way, the upper mold 320 is overlapped from above, and the upper and lower molds are tightly closed using a mold clamping member (not shown) or the like. Note that, as shown in the enlarged view of the main part in Fig. 22A, the lower mold 310 has a stepped portion 310A formed on the inner surface that constitutes a part of the cavity CV of the lower mold 310, into which both outer edges of the main body portion 82 of the lead frame 80 fit. Thus, the lead frame 80 can be positioned securely, and the occurrence of missing parts in the package 60 can be suppressed.

In this way, as shown in Fig. 22A, the lead pins 70 and the semiconductor chip 50 are set in cavities inside of the molds as insert molded parts or nests. Thereafter, as shown in Fig. 22B, the required molding resin is injected and filled into the cavities from the gate G of the upper mold 320, and after the resin has hardened, the mold is opened in the vertical direction from the parting line (P.L.). In this way, the semiconductor device 100D shown in Fig. 22A can be manufactured.

Note that the drawings in the embodiment and each configuration example described above are schematic, and the ratio of dimensions of each part may not necessarily match the actual one. Furthermore, naturally, the drawings include portions with different dimensional relationships and ratios. Moreover, various aspects can be applied as long as the same effects as those described in the above-described embodiments and configuration examples can be obtained.

### [Reference Signs List]

1A, 1A', 1A", 1A‴ Semiconductor package (package)
1B Semiconductor package (package)
1C Semiconductor package (package)
1D Semiconductor package (package)
2 Heat-dissipating lead frame (lead frame)
2' Heat-dissipating lead frame (lead frame)
2" Heat-dissipating lead frame (lead frame)
2‴ Heat-dissipating lead frame (lead frame)
2A Heat-dissipating fin (heat-dissipating portion)
2A' Heat-dissipating fin (heat-dissipating portion)
2B Mounting portion
2B' Mounting portion
2B" Mounting portion
2B‴ Mounting portion
2C Heat-dissipating pin (heat-dissipating portion)
2C" Heat-dissipating pin
2C‴ Heat-dissipating pin
3 Cover glass
4 Image sensor (semiconductor element)
10 Main body
10' Main body of package
10" Main body of package
10A Upper lid body (of interposer)
10B Interposer body
10C Intermediate frame (of interposer substrate)
10D Lower half body
10E Upper half body
11 Opening
12 Concave area
13 Pad electrode
14 Pad electrode
14' Electrode
15 Pad electrode
16 Large opening
20 Main body
30 BGA (ball grid array)
50 Semiconductor chip (with high heat generation)
50' Power transistor
60 Package
60' DIP-type package
60" DIP-type package
61 Stepped portion
61' Stepped portion
70 Lead pin
80 Lead frame
81 Heat-dissipating pin
82 Body portion
90 Lead frame
100A Semiconductor device
100B Semiconductor device
100C Semiconductor device
100D Semiconductor device
100E Semiconductor device
100F Semiconductor device
200 Metal
200A Four corner areas
200B Solid-line portion
200C Broken-line portion
210 Mold
220 Lower mold
230 Upper mold
d Step
B Base
CV Cavity
F Front surface
G Gate
GL Adhesive
H Head
H' Head
H1 Top surface
H2' Recess
H2" Recess
J1 Dedicated jig
J2 Dedicated jig
L Notch
M Thin film body
OP Opening
P Partition portion
R Rear surface
Y Wire
α Pin-free area
β Expansion area

## Claims

1. A heat-dissipating lead frame (2, 2', 2", 2‴, 80, 90) comprising:
a mounting surface (2B, 2B', 2B", 2B"', 82) for mounting a semiconductor chip (4, 50, 50') formed of a material having heat dissipation properties and provided at a center on a front surface side of a mounting portion (2B, 2B', 2B", 2B"', 82); and
a number of heat-dissipating portions (2A, 2A', 2C, 2C", 2C‴, 81), wherein the heat-dissipating portions (2A, 2A', 2C, 2C", 2C‴, 81) are provided around the mounting portion (2B, 2B', 2B", 2B"', 82), or around the mounting portion (2B, 2B', 2B", 2B"', 82), and on a rear surface side opposite to the mounting surface (2B, 2B', 2B", 2B"', 82), or wherein
the number of heat-dissipating portions (2A, 2A', 2C, 2C", 2C‴, 81) are provided on a rear surface side opposite to the mounting surface (2B, 2B', 2B", 2B"', 82) and each of the heat-dissipating portions (2C, 2C", 2C‴, 81) is formed only on an outer edge side of the rear surface side, avoiding directly below the center on the rear surface side of the mounting portion (2B, 2B', 2B", 2B"', 82),
with the mounting surface (2B, 2B', 2B", 2B‴, 82) suitable to face the front surface (F) of a semiconductor package (1A, 1B, 1C, 60, 60', 60"), the mounting surface (2B, 2B', 2B", 2B‴, 82) suitable to fit into an opening (11) provided in the semiconductor device package (1A, 1B, 1C, 60, 60', 60"), and the lead frame (2, 2', 2", 2‴, 80, 90) suitable to be attached to a rear surface (R) of the semiconductor device package (1A, 1B, 1C, 60, 60', 60").

2. The heat-dissipating lead frame (2, 2', 2", 2‴, 80, 90) according to claim 1, wherein the mounting surface (2B, 2B', 2B", 2B"', 82) has a substantially rectangular shape, and each of the heat-dissipating portions (2A, 2A', 2C, 2C", 2C‴, 81) is composed of a number of plate-shaped heat-dissipating fins (2A, 2A', 2A"") formed around a lower surface side of the mounting surface (2B, 2B', 2B", 2B"', 82).

3. The heat-dissipating lead frame (2, 2', 2", 2‴, 80, 90) according to claim 1, wherein the mounting surface (2B, 2B', 2B", 2B"', 82) has a substantially rectangular shape, and each of the heat-dissipating portions (2A, 2A', 2C, 2C", 2C‴, 81) is composed of a number of plate-shaped heat-dissipating fins (2A, 2A', 2A"") formed around an upper surface side of the mounting surface (2B, 2B', 2B", 2B"', 82).

4. The heat-dissipating lead frame (2, 2', 2", 2‴, 80, 90) according to claim 1, wherein
the mounting portion (2B, 2B', 2B", 2B"', 82) is formed in a flat plate shape, and
each of the heat-dissipating portions (2C, 2C", 2C‴, 81) is formed such that a heat-dissipating pin (2C, 2C", 2C‴, 81) protrudes from a rear surface side opposite to the mounting surface (2B, 2B', 2B", 2B"', 82) on the front surface side of the mounting portion (2B, 2B', 2B", 2B‴, 82).

5. The heat-dissipating lead frame (2, 2', 2", 2‴, 80, 90) according to claim 4, wherein each of the heat-dissipating portions (2C, 2C", 2C‴, 81) is the heat-dissipating pin (2C, 2C", 2C‴, 81) having a shape of any one of a triangular prism, a quadrangular prism, a cylinder, and a polygonal prism, and are geometrically regularly arranged.

6. The heat-dissipating lead frame (2, 2', 2", 2‴, 80, 90) according to claim 4 wherein
each of the heat-dissipating portions (2C, 2C", 2C‴, 81) is formed only on an outer edge side of the rear surface side, avoiding directly below the center on the rear surface side of the mounting portion (2B, 2B', 2B", 2B"', 82), and
a pin-free area (α) into which a jig (J1, J2) for supporting the semiconductor package (1A, 1B, 1C, 60, 60', 60") is inserted when die bonding the semiconductor chip (4, 50, 50') is provided on the rear surface side directly below a central portion of the front surface side of the mounting portion (2B, 2B', 2B", 2B"', 82).

7. The heat-dissipating lead frame (2, 2', 2", 2‴, 80, 90) according to claim 1, wherein each of the heat-dissipating portions (2C, 2C", 2C‴, 81) adjacent to each other is connected by a thin film body (M).

8. A semiconductor device package (100A, 100B, 100C, 100D, 100E, 100F) comprising:
an opening (11) provided on a center side of a main body (10, 10', 10", 10A, 10B, 10C, 10D, 10E) of a package (1A, 1B, 1C, 60, 60', 60"); and
a concave area (12) provided on at least a front surface side (F) of the main body (10, 10', 10", 10A, 10B, 10C, 10D, 10E) at a center side including the opening (11), and recessed from an outer edge side that is outside of the center side, wherein
a heat-dissipating lead frame (2, 2', 2", 2‴, 80, 90) according to any of claims 1 to 7 is attached to a rear surface side (R) of the main body (10, 10', 10", 10A, 10B, 10C, 10D, 10E) opposite to the front surface side (F).

9. The semiconductor device package (100A, 100B, 100C, 100D, 100E, 100F) according to claim 8, wherein
a mounting portion (2B, 2B', 2B", 2B‴, 82) on the center side of the lead frame (2, 2', 2", 2‴, 80, 90), on which the semiconductor element (4, 50, 50') is mounted, fits into the opening (11).

10. The semiconductor device package (100A, 100B, 100C, 100D, 100E, 100F) according to claim 8, wherein
the concave area (12) is provided not only on the front surface (F) of the main body (10, 10', 10", 10A, 10B, 10C, 10D, 10E) but also on the rear surface (R).

11. The semiconductor device package (100A, 100B, 100C, 100D, 100E, 100F) according to claim 8, wherein
an interposer (10B, 10C) is used in at least a part of the main body (10, 10', 10", 10A, 10B, 10C, 10D, 10E) of the package (1A, 1B, 1C, 60, 60', 60").

## Patentansprüche

1. Wärmeableitender Leitungsrahmen (2, 2', 2", 2"', 80, 90), umfassend:
eine Montagefläche (2B, 2B', 2B", 2B‴, 82) zum Montieren eines Halbleiterchips (4, 50, 50'), die aus einem Material mit wärmeableitenden Eigenschaften gebildet und in einer Mitte einer Vorderseite eines Montageabschnitts (2B, 2B', 2B", 2B‴, 82) bereitgestellt ist; und
eine Anzahl von wärmeableitenden Abschnitten (2A, 2A', 2C, 2C", 2C‴, 81), wobei die wärmeableitenden Abschnitte (2A, 2A', 2C, 2C", 2C‴, 81) um den Montageabschnitt (2B, 2B', 2B", 2B‴, 82) herum bereitgestellt sind, oder um den Montageabschnitt (2B, 2B', 2B", 2B‴, 82) herum und auf einer Rückseite gegenüber der Montagefläche (2B, 2B', 2B", 2B‴, 82), oder wobei
die Anzahl der wärmeableitenden Abschnitte (2A, 2A', 2C, 2C", 2C‴, 81) auf einer Rückseite gegenüber der Montagefläche (2B, 2B', 2B", 2B‴, 82) bereitgestellt sind und jeder der wärmeableitenden Abschnitte (2C, 2C", 2C‴, 81) nur auf einer äußeren Randseite der Rückseite ausgebildet ist und direkt unterhalb der Mitte auf der Rückseite des Montageabschnitts (2B, 2B', 2B", 2B‴, 82) vermieden wird,
wobei die Montagefläche (2B, 2B', 2B", 2B‴, 82) entsprechend der Vorderseite (F) eines Halbleitergehäuses (1A, 1B, 1C, 60, 60', 60") zugewandt sein kann, die Montagefläche (2B, 2B', 2B", 2B‴, 82) entsprechend in eine Öffnung (11) passen kann, die in dem Halbleitergehäuse (1A, 1B, 1C, 60, 60', 60") bereitgestellt ist, und der Leitungsrahmen (2, 2', 2", 2"', 80, 90) entsprechend auf einer Rückseite (R) des Halbleitergehäuses (1A, 1B, 1C, 60, 60', 60") befestigt sein kann.

2. Wärmeableitender Leitungsrahmen (2, 2, 2, 2, 80, 90) nach Anspruch 1, wobei
die Montagefläche (2B, 2B', 2B", 2B‴, 82) eine im Wesentlichen rechteckige Form aufweist, und
jeder der wärmeableitenden Abschnitte (2A, 2A', 2C, 2C", 2C", 81) aus einer Anzahl von plattenförmigen wärmeableitenden Rippen (2A, 2A', 2Aʺʺ) zusammengesetzt ist, die um eine Unterseite der Montagefläche (2B, 2B', 2B", 2B‴, 82) herum ausgebildet sind.

3. Wärmeableitender Leitungsrahmen (2, 2, 2, 2, 80, 90) nach Anspruch 1, wobei
die Montagefläche (2B, 2B', 2B", 2B‴, 82) eine im Wesentlichen rechteckige Form aufweist, und
jeder der wärmeableitenden Abschnitte (2A, 2A', 2C, 2C", 2C", 81) aus einer Anzahl von plattenförmigen Wärmeableitungsrippen (2A, 2A', 2Aʺʺ) zusammengesetzt ist, die um eine Oberseite der Montagefläche (2B, 2B', 2B", 2B‴, 82) herum ausgebildet sind.

4. Wärmeableitender Leitungsrahmen (2, 2, 2, 2, 80, 90) nach Anspruch 1, wobei
der Montageabschnitt (2B, 2B', 2B", 2B‴, 82) in einer flachen Plattenform ausgebildet ist, und
jeder der wärmeableitenden Abschnitte (2C, 2C", 2C‴, 81) so ausgebildet ist, dass ein wärmeableitender Stift (2C, 2C", 2C‴, 81) von einer Rückseite vorsteht, die der Montagefläche (2B, 2B', 2B", 2B‴, 82) auf der Vorderseite des Montageabschnitts (2B, 2B', 2B", 2B‴, 82) gegenüberliegt.

5. Wärmeableitender Leitungsrahmen (2, 2', 2", 2"', 80, 90) nach Anspruch 4, wobei
jeder der wärmeableitenden Abschnitte (2C, 2C", 2C‴, 81) der wärmeableitende Stift (2C, 2C", 2C‴, 81) ist, der die Form eines dreieckigen Prismas, eines viereckigen Prismas, eines Zylinders oder eines polygonalen Prismas aufweisen kann und geometrisch regelmäßig angeordnet ist.

6. Wärmeableitender Leitungsrahmen (2, 2', 2", 2‴, 80, 90) nach Anspruch 4 wobei
jeder der wärmeableitenden Abschnitte (2C, 2C",, 2C‴,, 81) nur auf einer Außenkantenseite der Rückseite ausgebildet ist, und direkt unterhalb der Mitte auf der Rückseite des Montageabschnitts (2B, 2B', 2B", 2B‴,, 82) vermieden wird, und
ein stiftfreier Bereich (a), in den eine Vorrichtung (J1, J2) zum Stützen des Halbleitergehäuses (1A, 1B, 1C, 60, 60', 60") eingesetzt wird, wenn das Chipbonden des Halbleiterchips (4, 50, 50') auf der Rückseite direkt unterhalb eines zentralen Abschnitts der Vorderseite des Montageabschnitts (2B, 2B', 2B", 2B‴, 82) bereitgestellt wird.

7. Wärmeableitender Leitungsrahmen (2, 2', 2", 2"', 80, 90) nach Anspruch 1, wobei
jeder der wärmeableitenden Abschnitte (2C, 2C", 2C‴, 81), die zueinander benachbart sind, durch einen Dünnschichtkörper (M) verbunden ist.

8. Halbleitergehäuse (100A, 100B, 100C, 100D, 100E, 100F), umfassend:
eine Öffnung (11), die auf einem Mittelteil eines Hauptkörpers (10, 10', 10", 10A, 10B, 10C, 10D, 10E) eines Gehäuses (1A, 1B, 1C, 60, 60', 60") bereitgestellt ist; und
einen konkaven Bereich (12), der auf mindestens einer Vorderseite (F) des Hauptkörpers (10, 10', 10", 10A, 10B, 10C, 10D, 10E) an einem Mittelteil bereitgestellt ist und die Öffnung (11) einschließt und von einer Außenkantenseite, die außerhalb des Mittelteils liegt, vertieft ist, wobei
ein wärmeableitender Leitungsrahmen (2, 2', 2", 2‴, 80, 90) nach einem der Ansprüche 1 bis 7 an einer Rückseite (R) des Hauptkörpers (10, 10', 10", 10A, 10B, 10C, 10D, 10E) gegenüber der Vorderseite (F) befestigt ist.

9. Halbleitergehäuse (100A, 100B, 100C, 100D, 100E, 100F) nach Anspruch 8, wobei
ein Montageabschnitt (2B, 2B', 2B", 2B‴, 82) im Mittelteil des Leitungsrahmens (2, 2', 2", 2"', 80, 90), auf dem das Halbleiterelement (4, 50, 50') montiert ist, in die Öffnung (11) eingepasst ist.

10. Halbleitergehäuse (100A, 100B, 100C, 100D, 100E, 100F) nach Anspruch 8, wobei
der konkave Bereich (12) nicht nur an der Vorderseite (F) des Hauptkörpers (10, 10', 10", 10A, 10B, 10C, 10D, 10E) bereitgestellt ist, sondern auch auf der Rückseite (R).

11. Halbleitergehäuse (100A, 100B, 100C, 100D, 100E, 100F) nach Anspruch 8, wobei
ein Interposer (10B, 10C) in mindestens einem Teil des Hauptkörpers (10, 10', 10", 10A, 10B, 10C, 10D, 10E) des Gehäuses (1A, 1B, 1C, 60, 60', 60") verwendet wird.

## Revendications

1. Grille de connexion de dissipation de chaleur (2, 2', 2", 2‴, 80, 90) comprenant :
une surface de montage (2B, 2B', 2B", 2B‴, 82) destinée au montage d'une puce semi-conductrice (4, 50, 50') formée d'un matériau présentant des propriétés de dissipation de chaleur et fournie au niveau d'un centre sur un côté de surface avant d'une partie de montage (2B, 2B', 2B", 2B‴, 82) ; et
un nombre de parties de dissipation de chaleur (2A, 2A', 2C, 2C", 2C‴, 81), dans laquelle les parties de dissipation de chaleur (2A, 2A', 2C, 2C", 2C‴, 81) sont prévues autour de la partie de montage (2B, 2B', 2B", 2B‴, 82), ou autour de la partie de montage (2B, 2B', 2B", 2B‴, 82), et sur un côté de surface arrière opposé à la surface de montage (2B, 2B', 2B", 2B‴, 82), ou dans laquelle
le nombre de parties de dissipation de chaleur (2A, 2A', 2C, 2C", 2C‴, 81) est prévu sur un côté de surface arrière opposé à la surface de montage (2B, 2B', 2B", 2B‴, 82) et chacune des parties de dissipation de chaleur (2C, 2C", 2C‴, 81) est formée uniquement sur un côté de bord externe du côté de surface arrière, en évitant directement en dessous du centre sur le côté de surface arrière de la partie de montage (2B, 2B', 2B", 2B‴, 82),
avec la surface de montage (2B, 2B', 2B", 2B‴, 82) adaptée pour faire face à la surface avant (F) d'un boîtier à semi-conducteur (1A, 1B, 1C, 60, 60', 60"), la surface de montage (2B, 2B', 2B", 2B‴, 82) étant adaptée pour s'insérer dans une ouverture (11) prévue dans le boîtier de dispositif à semi-conducteur (1A, 1B, 1C, 60, 60', 60"), et la grille de connexion (2, 2', 2", 2"', 80, 90) étant adaptée pour être fixé à une surface arrière (R) du boîtier de dispositif à semi-conducteur (1A, 1B, 1C, 60, 60', 60").

2. Grille de connexion de dissipation de chaleur (2, 2', 2", 2‴, 80, 90) selon la revendication 1, dans laquelle
la surface de montage (2B, 2B', 2B", 2B"', 82) présente une forme sensiblement rectangulaire, et
chacune des parties de dissipation de chaleur (2A, 2A', 2C, 2C", 2C", 81) est composée d'un certain nombre d'ailettes de dissipation de chaleur en forme de plaque (2A, 2A', 2A"") formées autour d'un côté de surface inférieur de la surface de montage (2B, 2B', 2B", 2B‴, 82).

3. Grille de connexion de dissipation de chaleur (2, 2', 2", 2"', 80, 90) selon la revendication 1, dans laquelle
la surface de montage (2B, 2B', 2B", 2B"', 82) présente une forme sensiblement rectangulaire, et
chacune des parties de dissipation de chaleur (2A, 2A', 2C, 2C", 2C", 81) est composée d'un certain nombre d'ailettes de dissipation de chaleur en forme de plaque (2A, 2A', 2A"") formées autour d'un côté de surface supérieure de la surface de montage (2B, 2B', 2B", 2B"', 82).

4. Grille de connexion de dissipation de chaleur (2, 2', 2", 2"', 80, 90) selon la revendication 1, dans laquelle
la partie de montage (2B, 2B', 2B", 2B‴, 82) présente une forme de plaque plate, et
chacune des parties de dissipation de chaleur (2C, 2C", 2C"', 81) est formée de telle sorte qu'une broche de dissipation de chaleur (2C, 2C", 2C"', 81) fait saillie d'un côté de surface arrière opposé à la surface de montage (2B, 2B', 2B", 2B‴, 82) sur le côté de surface avant de la partie de montage (2B, 2B', 2B", 2B‴, 82).

5. Grille de connexion de dissipation de chaleur (2, 2', 2", 2"', 80, 90) selon la revendication 4, dans laquelle
chacune des parties de dissipation de chaleur (2C, 2C", 2C"', 81) est la broche de dissipation de chaleur (2C, 2C", 2C"', 81) présentant une forme de l'un quelconque parmi un prisme triangulaire, un prisme quadrangulaire, un cylindre, et un prisme polygonal, et sont agencées géométriquement régulièrement.

6. Grille de connexion de dissipation de chaleur (2, 2', 2", 2"', 80, 90) selon la revendication 4, dans laquelle
chacune des parties de dissipation de chaleur (2C, 2C", 2C"', 81) est formée uniquement sur un côté de bord externe du côté de surface arrière, en évitant directement en dessous du centre du côté de surface arrière de la partie de montage (2B, 2B', 2B", 2B"', 82), et
une zone sans broche (a) dans laquelle un dispositif de serrage (J1, J2) destiné à supporter le boîtier à semi-conducteur (1A, 1B, 1C, 60, 60', 60") est inséré lorsque le collage de puce de la puce semi-conductrice (4, 50, 50') est prévu sur le côté de surface arrière directement en dessous d'une partie centrale du côté de surface avant de la partie de montage (2B, 2B', 2B", 2B‴, 82).

7. Grille de connexion de dissipation de chaleur (2, 2', 2", 2"', 80, 90) selon la revendication 1, dans laquelle
chacune des parties de dissipation de chaleur (2C, 2C", 2C‴, 81) adjacentes les unes aux autres est reliée par un corps de film mince (M).

8. Boîtier de dispositif à semi-conducteur (100A, 100B, 100C, 100D, 100E, 100F) comprenant :
une ouverture (11) située sur un côté central d'un corps principal (10, 10', 10", 10A, 10B, 10C, 10D, 10E) d'un boîtier (1A, 1B, 1C, 60, 60', 60") ; et
une zone concave (12) prévue sur au moins un côté de surface avant (F) du corps principal (10, 10', 10", 10A, 10B, 10C, 10D, 10E) au niveau d'un côté central comportant l'ouverture (11), et en retrait à partir d'un côté de bord externe qui est à l'extérieur du côté central, dans lequel
une grille de connexion de dissipation de chaleur (2, 2', 2", 2"', 80, 90) selon l'une quelconque des revendications 1 à 7 est fixée à un côté de surface arrière (R) du corps principal (10, 10', 10", 10A, 10B, 10C, 10D, 10E) opposé au côté de surface avant (F).

9. Boîtier de dispositif à semi-conducteur (100A, 100B, 100C, 100D, 100E, 100F) selon la revendication 8, dans lequel
une partie de montage (2B, 2B', 2B", 2B"', 82) sur le côté central de la grille de connexion (2, 2', 2 », 2"', 80, 90), sur laquelle l'élément semi-conducteur (4, 50, 50') est monté, s'adapte dans l'ouverture (11).

10. Boîtier de dispositif à semi-conducteur (100A, 100B, 100C, 100D, 100E, 100F) selon la revendication 8, dans lequel
la zone concave (12) est prévue non seulement sur la surface avant (F) du corps principal (10, 10', 10", 10A, 10B, 10C, 10D, 10E) mais également sur la surface arrière (R).

11. Boîtier de dispositif à semi-conducteur (100A, 100B, 100C, 100D, 100E, 100F) selon la revendication 8, dans lequel
un interposeur (10B, 10C) est utilisé dans au moins une partie du corps principal (10, 10', 10", 10A, 10B, 10C, 10D, 10E) du boîtier (1A, 1B, 1C, 60, 60', 60").
